(19)

**Europäisches Patentamt**
**European Patent Office**
**Office européen des brevets**

(11) **EP 4 588 605 A1**

(12) **EUROPEAN PATENT APPLICATION**
published in accordance with Art. 153(4) EPC

(43) Date of publication:
**23.07.2025 Bulletin 2025/30**

(21) Application number: **23865114.5**

(22) Date of filing: **02.08.2023**

(51) International Patent Classification (IPC):
**B23K 26/066** (2014.01)   **B23K 26/361** (2014.01)
**G09F 9/00** (2006.01)   **G09F 9/33** (2006.01)
**H01L 33/00** (2010.01)   **H01L 33/62** (2010.01)

(52) Cooperative Patent Classification (CPC):
**B23K 26/066; B23K 26/361; G09F 9/00;
G09F 9/33; H10H 20/80; H10H 20/857**

(86) International application number:
**PCT/JP2023/028273**

(87) International publication number:
**WO 2024/057754 (21.03.2024 Gazette 2024/12)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.09.2022 JP 2022145312**

(71) Applicants:
• **Dexerials Corporation
Shimotsuke-shi, Tochigi 323-0194 (JP)**
• **SHIN-ETSU CHEMICAL CO., LTD.
Tokyo 1000005 (JP)**

(72) Inventors:
• **TSUKAO, Reiji
Shimotsuke-shi, Tochigi 323-0194 (JP)**
• **HAYASHI, Naoki
Shimotsuke-shi, Tochigi 323-0194 (JP)**

• **WATANABE, Kazumu
Shimotsuke-shi, Tochigi 323-0194 (JP)**
• **NODA, Daiki
Shimotsuke-shi, Tochigi 323-0194 (JP)**
• **SHIRAIWA, Toshiki
Shimotsuke-shi, Tochigi 323-0194 (JP)**
• **YAMAOKA, Hiroshi
Yokohama-shi, Kanagawa 234-0053 (JP)**
• **KURATA, Masami
Yokohama-shi, Kanagawa 234-0053 (JP)**
• **USAMI, Taketo
Yokohama-shi, Kanagawa 234-0053 (JP)**
• **OGAWA, Yoshinori
Tokyo 100-0005 (JP)**
• **KONDO, Kazunori
Tokyo 100-0005 (JP)**

(74) Representative: **Müller-Boré & Partner
Patentanwälte PartG mbB
Friedenheimer Brücke 21
80639 München (DE)**

(54) **MASK, MASK MANUFACTURING METHOD, DISPLAY DEVICE MANUFACTURING METHOD, AND DISPLAY DEVICE**

(57)     Provided is a mask and a method for manufacturing the mask with excellent processability and transferability of individualized pieces, as well as a method for manufacturing a display device and a display device. By using a mask having a predetermined shape of a light-shielding portion that blocks laser light within an opening that transmits laser light, laser light is irradiated from the base material (21) side to the curable resin film (22) formed on the base material (21) to remove the curable resin film (22) in the irradiated portion (removal portion (23)), thereby forming individualized pieces of a predetermined shape composed of a curable resin film (22) with a reaction rate of 25% or less on the base material (21). This allows for excellent workability and transferability of the individualized pieces, thereby improving tact time.

**EP 4 588 605 A1**

**(Cont. next page)**

FIG.1

**Description**

TECHNICAL FIELD

This technology relates to a method for manufacturing an individualized-piece-film to individualize a connection film such as anisotropic conductive film (ACF) and adhesive film (NCF: non conductive film), and to an individualized-piece-film. This technology also relates to a method for manufacturing a display device that connects and arranges light-emitting elements via individualized-piece-film, and to a display device. In particular, this technology relates to a method for manufacturing a display device that connects and arranges LED elements such as mini-LEDs (light emitting diodes) and micro-LEDs, and to the display device. This application claims priority based on Japanese Patent Application No. 2022-145312, which was filed in Japan on September 13, 2022, and this application is hereby incorporated by reference.

BACKGROUND ART

The development of mini-LED and micro-LED displays is attracting attention as next-generation displays. Mini-LED and micro-LED displays are composed of arrays of minute light-emitting elements on a substrate, so they can omit the backlight required for LCD displays, making it possible to make the display thinner, and they can also achieve a wider color gamut, higher resolution, and lower power consumption.

Patent Document 1 discloses a method of joining LEDs with ACF. In the method described in Patent Document 1, the ACF is entirely pasted to an element mounting surface of a substrate, so the adhesive resin of the ACF and conductive particles remain between adjacent LEDs. Therefore, in a case where the light-emitting element array requires light transmissive properties, the transmission of light will be blocked, and it will not be possible to obtain excellent light transmissive properties. In addition, if the film is applied to the entire surface of the substrate, there are concerns that it will have a negative impact on productivity, such as increasing the number of repair man-hours when a defect occurs.

On the other hand, when ACF is attached only directly below the LEDs, the adhesive resin and conductive particles of the ACF do not remain between adjacent LEDs, and do not obstruct the transmission of light, so light transmissive properties can be obtained.

However, it is difficult to attach connection films such as ACF only directly below the LEDs. For example, when the individualized pieces are attached to the substrate after forming the individualized pieces of the connection film, if the shape of the individualized pieces is poor, the transferability of the individualized pieces to the substrate or LED will deteriorate, and the tact time for display manufacturing will deteriorate.

CITATION LIST

PATENT LITERATURE

Patent document 1: U.S. Patent Application Publication No. 2015/0255505

SUMMARY OF INVENTION

TECHNICAL PROBLEM

The present technology is proposed in light of this conventional situation and provides a mask and a method for manufacturing the mask that can obtain excellent workability and transferability of the individualized piece, as well as a method for manufacturing a display device and a display device.

SOLUTION TO PROBLEM

As a result of diligent research to solve the above problem, the present inventors found that the above purpose can be achieved by the following technology.

[1] A mask having a light-shielding portion of a predetermined shape that blocks laser light within an opening that allows laser light to pass through, wherein
the laser light is allowed to pass around the periphery of the light-shielding portion.
[2] The mask according to [1], wherein the predetermined shape is at least one selected from a polygon with obtuse angles, a polygon with rounded corners, an ellipse, an oval, and a circle.
[3] A method for manufacturing a mask, wherein with respect to a transparent substrate on which a light-shielding film is formed, the light-shielding film is removed so that the mask includes a light-shielding portion of a predetermined shape that blocks laser light within an opening that allows laser light to pass through.

[4] A method for manufacturing a display device, including:

a formation step of irradiating a curable resin film formed on a base material with laser light from the base material side to remove the curable resin film in the irradiated area, thereby forming individualized pieces of a predetermined shape composed of the curable resin film with a reaction rate of 25% or less on the base material;

a transfer step of transferring the individualized pieces of the predetermined shape to a predetermined position on a wiring substrate or to an electrode surface of a light-emitting element; and

a mounting step of mounting the light-emitting element to the wiring substrate via the transferred individualized pieces.

[5] The method for manufacturing a display device according to [4], wherein in the formation step, the laser light is irradiated via the mask having a light-shielding portion of the predetermined shape.

[6] The method for manufacturing a display device according to [4], wherein in the transfer step, the individualized pieces of a predetermined shape are transferred to a predetermined position on the wiring substrate or to an electrode surface of the light-emitting element by irradiating laser light from the base material side.

[7] The method for manufacturing a display device according to [4], wherein the predetermined shape is at least one selected from a polygon with obtuse angles, a polygon with rounded corners, an ellipse, an oval, and a circle.

[8] The method for manufacturing a display device according to [4], wherein the individualized pieces are arranged on the base material.

[9] The method for manufacturing a display device according to [8], wherein the distance between the individualized pieces is 10 $\mu$m or more.

[10] A display device, including:

a plurality of light-emitting elements;

a wiring substrate on which the light-emitting elements are arranged; and

a cured film that connects the plurality of light-emitting elements to the wiring substrate, wherein

the cured film is made by curing individualized pieces of a predetermined shape composed of a curable resin film, and

the predetermined shape is at least one selected from a polygon with obtuse angles, a polygon with rounded corners, an ellipse, an oval, and a circle.

[11] The display device according to [10], wherein the distance between the individualized pieces is 10 $\mu$m or more.

[12] The display device according to [10], wherein the light-emitting elements are arranged in units of subpixels that constitute a pixel.

[13] The display device according to [10], wherein the individualized pieces are arranged on the wiring substrate in units of subpixels or pixels.

ADVANTAGEOUS EFFECTS OF INVENTION

According to the present technology, it is possible to obtain excellent processability and transferability of individualized pieces, and to improve tact time.

BRIEF DESCRIPTION OF DRAWINGS

FIG. 1 is a schematic view illustrating an example of a laser lift-off device according to the present embodiment.

FIG. 2 is an explanatory view of an example of the method for manufacturing an individualized-piece-film, shown as Implementation 1, in which FIG. 2 (A) shows a curable resin film substrate with a curable resin film formed on the base material, FIG. 2 (B) shows the removal portion being peeled off in the first direction, FIG. 2 (C) shows the removal portion being peeled off in the second direction, and FIG. 2 (D) shows an individualized-piece-film with an individualized pieces of curable resin film formed on the base material.

FIG. 3 (A) is a schematic view of an example of a mask having a rectangular window of the opening, and FIG. 3 (B) is a schematic view of an example of the irradiation of laser light that has passed through the opening of the mask.

FIG. 4 (A) is a microscope photograph showing an example of individualized pieces that have burrs occurred during an individualization process, and FIG. 4 (B) is a microscope photograph showing an example of individualized pieces that have curling or chipping occurred during transfer.

FIG. 5 (A) is a schematic view of an example of a mask having a light-shielding portion within the window of the opening, and FIG. 5 (B) is a schematic view of an example of the irradiation of laser light that has passed through the opening of the mask.

FIG. 6 is a schematic view of an example of a mask having multiple light-shielding portions within the window of the opening.

FIG. 7 is a schematic view illustrating examples of the shape of the opening of the mask, in which FIG. 7 (A) shows a mask having a rectangular light-shielding portion within the window of the opening, FIG. 7 (B) shows a mask having a square light-shielding portion within the window of the opening, FIG. 7 (C) shows a mask having a rectangular light-shielding portion with rounded corners within the window of the opening, and FIG. 7 (D) shows a mask having a circular light-shielding portion within the window of the opening.

FIG. 8 is a cross-sectional view schematically illustrating the anisotropic conductive film provided on the base material.

FIG. 9 is a cross-sectional view schematically illustrating a state in which an individualized-piece-film and a wiring substrate face each other.

FIG. 10 is a cross-sectional view schematically illustrating a state in which the individualized pieces of an anisotropic conductive film are transferred to and arranged in predetermined positions on the wiring substrate by irradiating laser light from the base material side.

FIG. 11 is a cross-sectional view schematically illustrating a state in which light-emitting elements are mounted on the individualized pieces arranged in predetermined positions on the wiring substrate.

FIG. 12 is a cross-sectional view schematically illustrating a state in which the individualized pieces of an anisotropic conductive film are transferred to and arranged in the electrode position of the wiring substrate by irradiating laser light from the base material side.

FIG. 13 is a cross-sectional view schematically illustrating a state in which light-emitting elements are mounted on the individualized pieces arranged on the wiring substrate in units of electrodes.

FIG. 14 is a cross-sectional view schematically illustrating a state in which individualized pieces of an anisotropic conductive film provided on the base material and light-emitting elements arranged on the transfer substrate face each other.

FIG. 15 is a cross-sectional view schematically illustrating a state in which individualized pieces of an anisotropic conductive film are transferred to light-emitting elements arranged on the transfer substrate by irradiating laser light from the base material side.

FIG. 16 is a cross-sectional view schematically illustrating a state in which light-emitting elements to which the individualized pieces have been transferred are retransferred to a wiring substrate.

FIG. 17 is a view illustrating the positional deviation of the individualized pieces before and after transfer.

FIG. 18 schematically illustrates a fabrication method of a mounting body, in which FIG. 18 (A) shows the step of preparing individualized pieces, FIG. 18 (B) shows the step of transferring the individualized pieces to a substrate, FIG. 18 (C) shows the step of temporarily fixing a μLED element, and FIG. 18 (D) shows the step of pressure bonding the μLED element.

FIG. 19 is a plan view schematically illustrating an evaluation substrate for a lighting test.

FIG. 20 (A) is a plan view schematically illustrating an electrode surface of the μLED element, and FIG. 20 (B) is a plan view schematically illustrating a μLED element mounted on an evaluation substrate.

FIG. 21 is a plan view schematically illustrating the mask shape of Example 1.

FIG. 22 is a plan view schematically illustrating the mask shape of Example 3.

FIG. 23 is a plan view schematically illustrating the mask shape of Example 4.

FIG. 24 is a plan view schematically illustrating the mask shape of Example 5.

FIG. 25 is a microscope photograph showing the rectangular individualized pieces in Example 5.

FIG. 26 is a plan view schematically illustrating the mask shape of Example 6.

FIG. 27 is a plan view schematically illustrating the mask shape of Example 7.

FIG. 28 is a plan view schematically illustrating the mask shape of Example 8.

FIG. 29 is a microscope photograph showing the elliptical individualized pieces of Example 8.

FIG. 30 is a plan view schematically illustrating the mask shape of Example 9.

FIG. 31 is a microscope photograph showing the circular individualized pieces of Example 9.

DESCRIPTION OF EMBODIMENTS

With reference to the drawings, the embodiments of the present technology are described in detail below in the following order.

1. METHOD FOR MANUFACTURING INDIVIDUALIZED-PIECE-FILM

2. INDIVIDUALIZED-PIECE-FILM

3. METHOD FOR MANUFACTURING DISPLAY DEVICE

4. DISPLAY DEVICE

5. EXAMPLES

1. METHOD FOR MANUFACTURING INDIVIDUALIZED-PIECE-FILM

The method for manufacturing an individualized-piece-film in this embodiment includes irradiating a curable resin film formed on a base material with laser light from the base material side to remove the curable resin film in the irradiated area, thereby forming individualized pieces of a predetermined shape composed of the curable resin film on the base material. The reaction rate of the individualized pieces of the predetermined shape is preferably 25% or less, more preferably 20% or less, and even more preferably 15% or less. This allows for excellent workability and transferability of the individualized pieces.

The reaction rate of the curable resin film before laser irradiation and the reaction rate of the individualized pieces obtained after laser irradiation can be measured using FT-IR, e.g., by determining the reduction rate of the reactive groups. If the individualized pieces are small, the reaction rate can be measured from the edge of the film where the individualized pieces have been punched out. For example, it is preferable to measure the reaction rate of the individualized pieces before laser irradiation within 8 hours of taking them out of the refrigerator and at room temperature and to measure the reaction rate of the individualized pieces after laser irradiation within 8 hours at room temperature after laser irradiation.

In the case of a curable resin film that uses the reaction of an epoxy compound, e.g., the reaction rate can be measured using FT-IR by preparing a sample as follows. First, after laser irradiation, individualized pieces remaining on the substrate are sampled using a pen-type cutter with a sharp tip to obtain a sample after laser irradiation. Next, the sample is placed on a diamond cell, flattened thinly on the diamond cell, and attached to a sample holder to set in the main unit of the device.

The diamond cell used for this measurement is a set of two pieces, and the sample is sandwiched between the two cell plates and tightened and crushed. After that, the measurement is carried out using one of the cell plates with the sample adhered. The amount of sample required for measurement is extremely small. If the sample is too large, it will not be possible to crush it thinly, so the measurement will be carried out with the sample film thickness in its thick state. As a result, the baseline will drop or become slanted, and the peaks will saturate, making it difficult to analyze the spectrum. Therefore, it is preferable to sample by an amount that can be adjusted to a thin state on the diamond cell (e.g., a film thickness of 10 $\mu$m or less).

Detector sensitivity is greatly improved by cooling, so the detector is cooled with liquid nitrogen for approximately 30 minutes prior to measurement. The FT-IR measurement conditions are set as follows.

Measurement method: transmission type measurement
Measurement temperature: 25°C
Measurement humidity: 60% or less
Measurement time: 12 sec
Spectral range of detector: 4,000 to 700 cm$^{-1}$

Then, the diamond cell is set in the infrared microscope to perform background measurement. The background measurement position should be as close as possible to the sample measurement position to obtain a good baseline. Next, the sample after laser irradiation is irradiated with infrared light to obtain the IR spectrum of the curable resin film after laser irradiation. In the same way as the sample after laser irradiation described above, the curable resin film before laser irradiation (before individualization) is sampled using a pen-type cutter with a sharp tip to obtain the IR spectrum of the curable resin film before laser irradiation. The reaction rate can be obtained by measuring the peak height of the methyl group (around 2,930 cm$^{-1}$) and the epoxy group (around 914 cm$^{-1}$) in the IR spectrum, and then calculating the ratio of the peak height of the epoxy group to the peak height of the methyl group before and after the reaction (before and after laser irradiation), as shown in the following formula.

$$\text{reaction rate } (\%) = \{1 - (a / b) / (A / B)\} \times 100$$

In the above formula, A is the peak height of the epoxy group before the reaction, B is the peak height of the methyl group before the reaction, a is the peak height of the epoxy group after the reaction, and b is the peak height of the methyl group after the reaction. In the case where another peak overlaps with the epoxy group peak, the peak height of the sample that has been fully cured (reaction rate 100%) can be considered as 0%.

In the case of a curable resin film that uses the reaction of (meth)acrylate compounds, as with the case of the epoxy compound, for example, the reaction rate can be obtained by measuring the peak height of the methyl group (around 2,930 cm$^{-1}$) and (meth)acryloyl group (around 1,635 cm$^{-1}$) in the infrared absorption spectrum, and then calculating the ratio of the peak height of the (meth)acryloyl group to the peak height of the methyl group before and after the reaction.

If the peak height of the (meth)acryloyl group is small, or if the sample contains alicyclic epoxy or oxetanyl groups, the reaction rate can be determined by preparing a sample as follows and using high-performance liquid chromatography (HPLC), for example. First, after laser irradiation, the individualized pieces remaining on the substrate are sampled using a pen-type cutter with a sharp tip to obtain a sample after laser irradiation. Next, after collecting a sample weighing at least 0.015 mg, it is placed in a vial and the extraction solvent, acetonitrile, is added. The extraction solvent volume is calculated by determining an arbitrary concentration in the range of 0.025 to 0.25%. Then, the vial is set in the main body of the measurement device to measure HPLC of the individualized pieces remaining on the substrate after laser irradiation, under the following measurement conditions, for example. In the same way as the sample after laser irradiation described above, the curable resin film before laser irradiation (before individualization) is sampled using a pen-type cutter with a sharp tip, and HPLC is measured for the curable resin film before laser irradiation.

Extraction: ACN 0.025 to 0.25%
Instrument: UPLC (manufactured by Waters)
Gradient conditions: A60B40 (hold for 1 min) then A1B99 (hold for 6 min) after 5 min

*A is water/acetonitrile = 9: 1, B is acetonitrile

Flow rate: 0.4 mL/min
Column: 10 cm
Measurement temperature: 40°C
Injection volume: 5 μL

From the chromatogram obtained by HPLC, the reaction rate of the individualized piece can be calculated using the following formula based on the decay rate of the reactive component before and after the reaction (before and after laser irradiation).

$$\text{Reaction rate (\%)} = \{1 - c / C\} \times 100$$

In the above formula, C is the peak height or area of the reactive component before the reaction, and c is the peak height or area of the reactive component after the reaction.

The base material only needs to be transparent to laser light, and quartz glass, which has a high light transmissivity across the entire wavelength range, is particularly preferable. The curable resin film is not particularly limited as long as it cures with energy such as heat and light, and can be selected as appropriate from thermo-curable binders, photo-curable binders, and thermo/photo-curable binders, for example. It is preferable to include a reaction initiator. In addition, the curable resin film can be formed using known methods such as mixing, application, and drying.

LASER LIFT-OFF DEVICE

For example, a laser lift-off (LLO) device can be used as a device for forming individualized pieces of a predetermined shape by irradiating laser light. The laser lift-off device is a device that irradiates a material layer formed on a base material with laser light and peels off the material layer from the base material; an example of the laser lift-off device is "Invisi LUM-XTR (product name)" manufactured by Shin-Etsu Chemical.

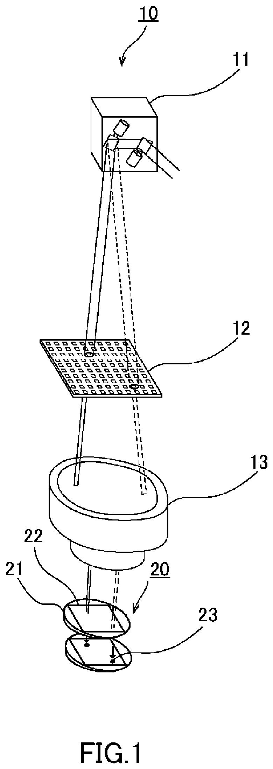

FIG. 1 is a schematic view illustrating an example of a laser lift-off device according to the present embodiment. As shown in FIG. 1, the laser lift-off device 10 includes a laser scanner 11 that scans the optical axis of the laser light, a mask 12 that has a plurality of openings of a predetermined shape and predetermined pitch, a projection lens 13 that reduces and projects the laser light onto the donor substrate, a donor stage that holds the donor substrate, and a receptor stage that holds the receptor substrate. In the formation of an individualized-piece-film, a curable resin film substrate 20 with a curable resin film 22 formed on a base material 21 is held on the donor stage as a donor substrate, and the removal portion 23 of the curable resin film separated from the curable resin film substrate 20 is received by the receptor substrate.

As a laser device, e.g., an excimer laser that oscillates laser light with a wavelength of 180 nm to 360 nm can be used. The oscillation wavelengths of excimer lasers are, e.g., 193, 248, 308, and 351 nm, and an appropriate oscillation wavelength can be selected from these according to the light absorption properties of the material of the curable resin film 22. In addition, if a release material is placed between the base material 21 and the curable resin film 22, the oscillation wavelength can be selected appropriately according to the light absorption properties of the release material.

The laser scanner 11 has a scanning mirror consisting of, e.g., a two-axis galvanometer scanner, which directs the laser light toward the opening on the mask 12 and scans the optical axis of the laser light in the X-axis and Y-axis directions while controlling the pulse irradiation of the laser light.

The mask 12 has a pattern of an array of windows of a predetermined size at a predetermined pitch so that the irradiation of laser light at the interface between the base material 21 and the curable resin film 22 has a predetermined shape. For example, the mask has a pattern applied by chrome plating to form light-shielding portions, and the window portions that have not been chrome-plated allow laser light to pass through, while the chrome-plated portions block laser light.

The projection lens 13 projects laser light that has passed through the pattern of the mask 12 onto the donor substrate. In addition, the donor stage has a moving mechanism that moves it at least in the X and Y axes to move the irradiation position of laser light on the donor substrate.

The laser lift-off device 10 constitutes a scanning type reduction projection optical device that includes the laser scanner 11, the mask 12, the field lens disposed between the laser scanner 11 and the mask 12, and the reduction projection lens 13 that is telecentric at least on the image side.

The incident light from the laser device enters the telescope optics and is propagated to the laser scanner 11 installed at the rear of the telescope optics. The laser light just before it enters the laser scanner 11 is adjusted by the telescope optics so that it becomes roughly parallel light at any position within the movement range of the X-axis and Y-axis of the donor stage, and enters the laser scanner 11 at roughly the same size and the same angle (perpendicular).

The laser light that passes through the laser scanner 11 enters the mask 12 via the field lens, and the laser light that passes through the pattern of the mask 12 enters the projection lens 13. The laser light emitted from the projection lens 13 enters from the base material 21 side and is projected accurately in the shape of the openings of the mask 12 onto the predetermined position at the interface between the base material 21 and the curable resin film 22. The laser light is projected from the openings in the mask onto the curable resin film, and the curable resin film 22 in the projected area is removed, leaving the curable resin film in the shape corresponding to the light-shielding portion.

The pulse energy of the laser light that is imaged at the interface between the base material 21 and the curable resin film 22 is preferably 0.001 to 2J, more preferably 0.01 to 1.5J, and even more preferably 0.1 to 1J. The fluence is preferably 0.001 to 2 J/cm$^2$, more preferably 0.01 to 1 J/cm$^2$, and even more preferably 0.05 to 0.5 J/cm$^2$. The pulse width (irradiation time) is preferably 0.01 to $1 \times 10^9$ picoseconds, more preferably 0.1 to $1 \times 10^7$ picoseconds, and even more preferably 1 to $1 \times 10^5$ picoseconds. The pulse frequency is preferably 0.1 to 10,000 Hz, more preferably 1 to 1,000 Hz, and even more preferably 1 to 100 Hz. The number of irradiation pulses is preferably between 1 and 30,000,000.

Such a laser lift-off device can generate an impact wave at the interface between the base material 21 and the curable resin film 22, peel off the removal portion 23 of the curable resin film 22 from the base material 21, and form individualized pieces of a predetermined shape with high accuracy and high efficiency by the remaining portion on the base material 21, thereby achieving excellent workability. In addition, because the effect of the irradiation of laser light on the individualized pieces of the predetermined shape is small, the reaction rate of the individualized pieces can be made to be 25% or less, preferably 20% or less, and even more preferably 15% or less, so that excellent transferability can be obtained. The reaction rate can be measured using, e.g., FT-IR.


Implementation 1


The method for manufacturing an individualized-piece-film shown as Implementation 1 uses a mask having a rectangular window of the opening to peel off unnecessary portions of the curable resin film from the base material, thereby forming a rectangular individualized piece with the remaining portions of the curable resin film.

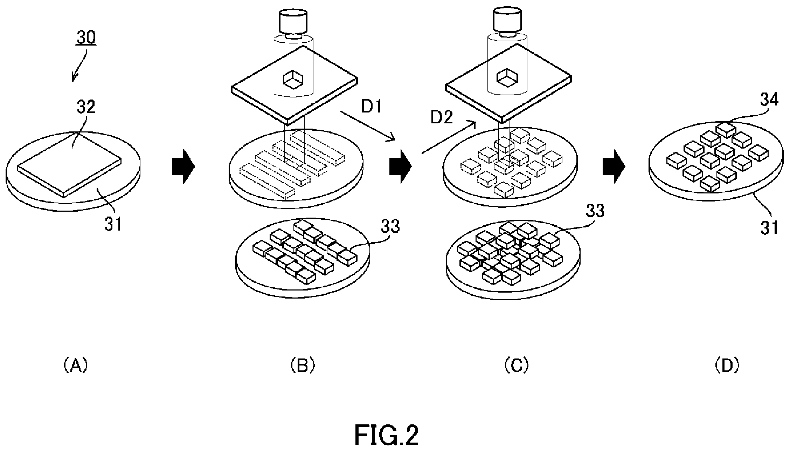

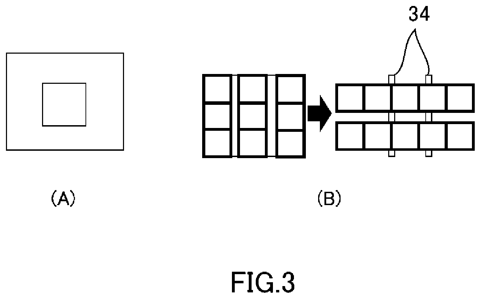

FIG. 2 is an explanatory view of an example of the method for manufacturing an individualized-piece-film, shown as Implementation 1, in which FIG. 2 (A) shows a curable resin film substrate with a curable resin film formed on the base material, FIG. 2 (B) shows the removal portion being peeled off in the first direction, FIG. 2 (C) shows the removal portion being peeled off in the second direction, and FIG. 2 (D) shows an individualized-piece-film with an individualized pieces of curable resin film formed on the base material. In addition, FIG. 3 (A) is a schematic view of an example of a mask having a rectangular window of the opening, and FIG. 3 (B) is a schematic view of an example of the irradiation of laser light that has passed through the opening of the mask. In FIGS. 2 and 3, the mask opening is shown as a single opening, but it is preferable for there to be a plurality of openings arranged at a predetermined pitch.

First, as shown in FIG. 2 (A), a curable resin film substrate 30 is prepared, with a curable resin film 32 formed on a base material 31. Next, as shown in FIG. 2 (B) and FIG. 3 (B), the curable resin film substrate 30 is turned over, and laser light is irradiated from the base material 31 side, so that the rectangular removal portion 33 of the curable resin film 32 is peeled off by the laser light that passes through the rectangular window of the opening of the mask. Then, as shown in FIG.

3 (B), the range of the rectangular removal portion 33 is moved in the first direction D1 to form a curable resin film with the first direction D1 as the longitudinal direction and the second direction D2, which is orthogonal to the first direction D1, as the transverse direction.

Next, as shown in FIGS. 2 (C) and 3 (B), the range of the rectangular removal portion 33 is moved in the second direction D2 with respect to the curable resin film with the first direction D1 as the longitudinal direction and the second direction D2, which is orthogonal to the first direction D1, as the transverse direction. This can form a rectangular individualized piece 34 with a predetermined width in the first direction D1 and a predetermined width in the second direction D2, as shown in FIG. 2 (D).

When moving the range of the rectangular removal portion 33 in the first or second direction, it is preferable to overlap the range of the rectangular removal portion 33. This suppresses burrs from forming during the individualization process and suppresses curling or chipping during the individualized piece transfer step.

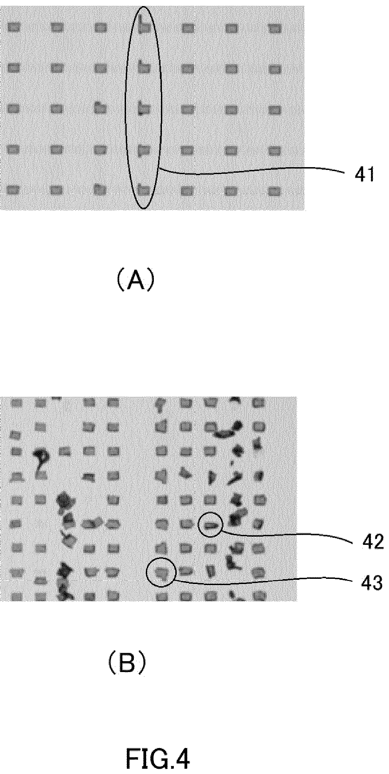

FIG. 4 (A) is a microscope photograph showing an example of individualized pieces that have burrs occurred during an individualization process, and FIG. 4 (B) is a microscope photograph showing an example of individualized pieces that have curling or chipping occurred during transfer. In the case of moving the range of the removal portion, if the overlap of the range of the removal portion is insufficient, individualized pieces 41 may be formed in which burrs occur at the interface between adjacent ranges of the removal portion as shown in FIG. 4 (A). The individualized pieces 41 in which burrs occur become difficult to transfer to the correct position, and as shown in FIG. 4 (B), they become individualized pieces 42 in which curling occurs or individualized pieces 43 in which chipping occurs, so that transfer success rate decreases.

Implementation 2

The method for manufacturing an individualized-piece-film shown as Implementation 2 uses a mask having a light-shielding portion of a predetermined shape formed in the window of the opening to peel off unnecessary portions of the curable resin film around the individualized pieces from the base material, thereby forming individualized pieces of the predetermined shape with the remaining portions of the curable resin film.

In Implementation 2, the mask (photomask) used in the laser lift-off device has a light-shielding portion of a predetermined shape that shields the laser light in the opening that transmits the laser light to pass the laser light around the periphery of the light-shielding portion. With this type of structure, the irradiation of laser light to the opening of the mask allows unnecessary portions around the individualized pieces to be peeled off. In addition, as described later, the shape of the light-shielding portion is preferably at least one selected from a polygon with obtuse angles, a polygon with rounded corners, an ellipse, an oval, and a circle. This allows the production of individualized pieces with less curling or chipping when transferring them using LLO.

Such a mask can be obtained, with respect to a transparent substrate on which a light-shielding film is formed, by removing the light-shielding film so that the mask includes a light-shielding portion of a predetermined shape that blocks laser light within the opening that allows laser light to pass through. Specifically, the above-described mask can be manufactured by preparing photomask blanks provided with a light-shielding film on a quartz glass substrate by vapor deposition of chromium or the like, evenly applying a resist (photosensitive resin) on the front surface of the photomask blanks, and then performing an exposure step of drawing a pattern with a light-shielding portion of a predetermined shape in the opening using an electron beam, a development step of removing the resist exposed by the electron beam (in some cases, the portions not exposed may be removed), an etching step of dry-etching the exposed portions of the light-shielding film using a reactive gas, and a removal step of removing the remaining resist.

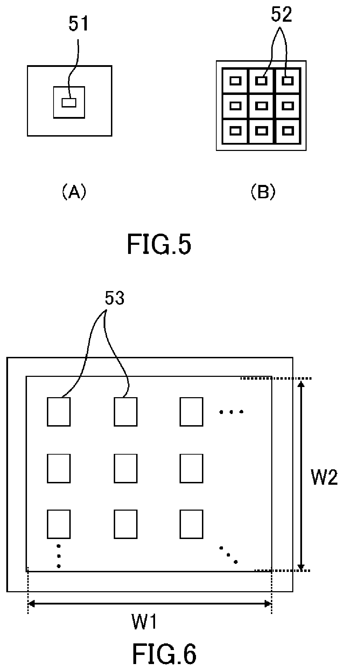

FIG. 5 (A) is a schematic view of an example of a mask having a light-shielding portion within the window of the opening, and FIG. 5 (B) is a schematic view of an example of the irradiation of laser light that has passed through the opening of the mask. In FIGS. 5 (A) and 5 (B), there is one opening in the mask, but it is preferable to have multiple openings arranged at a predetermined pitch.

First, as in Implementation 1, a curable resin film substrate with a curable resin film formed on the base material is prepared, the curable resin film substrate is turned over, and laser light is irradiated from the base material side to peel off the removal portion of the curable resin film by the laser light that passes through the opening of the mask. As shown in FIG. 5 (A), the opening of the mask has a rectangular light-shielding portion 51 in the center of the rectangular window, so the removal portion has a donut shape with a rectangular hole at the center of the rectangle. It is preferable that the light-shielding portions are isolated in the center of the window and are not connected to the window frame. By leaving only the light-shielding portions in the window, the removal of the unnecessary portion can be performed without moving in the first and second directions described above. Then, as shown in FIG. 5 (B), the range of the rectangular removal portion is moved in the first direction and the second direction, which is orthogonal to the first direction, and the same operation is performed to form rectangular individualized pieces 52 of the same shape aligned in the first and second directions.

The method for manufacturing an individualized-piece-film shown as Implementation 2 that includes the light-shielding portion 51 for forming the individualized pieces 52 within the window of the opening of the mask can reliably remove the curable resin film around the individualized pieces 52. This prevents burrs from forming during the individualization process and suppresses curling and chipping during the individualized piece transfer step.

FIG. 6 is a schematic view of an example of a mask having multiple light-shielding portions within the window of the opening. In the aforementioned FIGS. 5 (A) and 5 (B), there is one light-shielding portion within the window of the opening of the mask, but, e.g., as shown in FIG. 6, there may be multiple light-shielding portions 53 formed within the window of the opening at a predetermined pitch in the X-axis direction and at a predetermined pitch in the Y-axis direction. The size of the window (W1 x W2) can be determined based on the size of the mask and the maximum value of the effective range of the irradiation of laser light. By using such a mask, it is possible to form multiple individualized pieces with a single irradiation of laser light.

EXAMPLE OF OPENING SHAPE

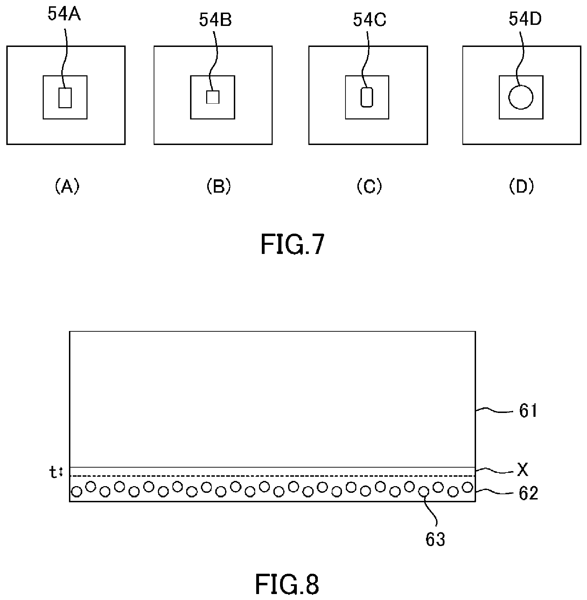

FIG. 7 is a schematic view illustrating examples of the shape of the opening of the mask, in which FIG. 7 (A) shows a mask having a rectangular light-shielding portion within the window of the opening, FIG. 7 (B) shows a mask having a square light-shielding portion within the window of the opening, FIG. 7 (C) shows a mask having a rectangular light-shielding portion with rounded corners within the window of the opening, and FIG. 7 (D) shows a mask having a circular light-shielding portion within the window of the opening.

The opening of the mask may have a rectangular light-shielding portion 54A within the window of the opening, as shown in FIG. 7 (A), a square light-shielding portion 54B, as shown in FIG. 7 (B), a rectangular light-shielding portion 54C with rounded corners, as shown in FIG. 7 (C), or a circular light-shielding portion 54D, as shown in FIG. 7 (D). This makes it possible to obtain individualized pieces with rectangular, square, rounded rectangular, or circular shapes that are projected from the shape of the light-shielding portion. From the perspective of the workability of the individualized pieces and the transferability with LLO, the light-shielding portion is preferably a polygon with obtuse angles (angles greater than 90° and less than 180°), a polygon with rounded corners, an ellipse, an oval, or a circle. If the light-shielding portion has sharp corners, the workability of the individualized pieces will deteriorate, and the frequency of individualized pieces curling or chipping during transfer by LLO will increase.

2. INDIVIDUALIZED-PIECE-FILM

The individualized-piece-film of this embodiment can be obtained by the method for manufacturing an individualized-piece-film described above. In other words, the individualized-piece-film includes a base material and an individualized pieces of a predetermined shape composed of a curable resin film. The reaction rate of the individualized pieces of the predetermined shape is preferably 25% or less, more preferably 20% or less, and even more preferably 15% or less. This allows for excellent transferability of the individualized pieces.

As mentioned above, the shape of the individualized pieces is preferably at least one of a polygon with obtuse angles, a polygon with rounded corners, an ellipse, an oval, or a circle, in order to prevent curling or chipping when transferring the individualized pieces using LLO. As mentioned above, the base material can be any material that is transparent to laser light, and quartz glass, which has a high light transmissivity across the entire wavelength range, is particularly preferable.

The dimensions (vertical dimension x horizontal dimension) of the individualized pieces are set appropriately according to the dimensions of the electronic components or the electrodes of the electronic components to be connected, and the ratio of the area of the individualized pieces to the area of the electronic components is preferably 0.5 to 5.0, more preferably 0.5 to 4.0, and even more preferably 0.5 to 2.0. The thickness of the individualized pieces is preferably 1 $\mu$m or more and 10 $\mu$m or less, more preferably 1 $\mu$m or more and 6 $\mu$m or less, and even more preferably 2 $\mu$m or more and 4 $\mu$m or less. The thickness of the individualized pieces can be measured using a known micrometer, digital thickness gauge, laser displacement meter, and the like, and for example, by measuring at ten or more locations and calculating the average. It is preferable that all the dimensions of the individualized pieces are the same, but in order to increase the design flexibility of the connection structure, there may be multiple types.

In addition, the distance between the individualized pieces on the base material is preferably 3 $\mu$m or more, more preferably 5 $\mu$m or more, and even more preferably 10 $\mu$m or more. The upper limit of the distance between the individualized pieces is preferably 3,000 $\mu$m or less, more preferably 1,000 $\mu$m or less, and even more preferably 500 $\mu$m or less. If the distance between the individualized pieces is too small, it will be difficult to transfer the individualized pieces, and if the distance between the individualized pieces is too large, it will be preferable to paste the individualized pieces. The distance between the individualized pieces can be measured using a microscope (optical microscope, metal microscope, and electron microscope, among others).

CURABLE RESIN FILM

As mentioned above, curable resin film is not particularly limited as long as it cures with energy such as heat and light, and can be selected as appropriate from thermo-curable binders, photo-curable binders, and thermo/photo-curable binders, for example.

Examples of the thermo-curable binder may include thermal anionic polymerization type resin compositions containing epoxy compounds and thermal anionic polymerization initiators, thermal cationic polymerization resin compositions containing epoxy compounds and thermal cationic polymerization initiators, and thermal radical polymerization type resin compositions containing (meth)acrylate compounds and thermal radical polymerization initiators. Examples of the photo-curable binder may include photo cationic polymerization type resin compositions containing epoxy compounds and photo cationic polymerization initiators, and thermal radical polymerization type resin compositions containing (meth)acrylate compounds and photo radical polymerization initiators. Examples of the thermo/photo-curable binder may include mixtures of thermo-curable binders and photo-curable binders. The term (meth)acrylate compound refers to both acrylic monomers (oligomers) and methacrylic monomers (oligomers).

THERMAL CATIONIC POLYMERIZATION RESIN COMPOSITION

As a specific example of the thermo-curable binder, a thermal cationic polymerization resin composition that includes film-forming resins, epoxy compounds, and thermal cationic polymerization initiators will be explained in the following.

As the film-forming resin, e.g., a high-molecular-weight resin with an average molecular weight of 10,000 or more is used, and from the perspective of film-forming properties, an average molecular weight of around 10,000 to 80,000 is preferable. Examples of the film-forming resin may include butyral resin, phenoxy resin, polyester resin, polyurethane resin, polyester-urethane resin, acryl resin, and polyimide resin, and these can be used individually or in combination with two or more. Among these, butyral resin is preferable from the perspective of film formation conditions and connection reliability. The content of the film-forming resin is preferably 20 to 70 parts by mass, more preferably 30 to 60 parts by mass or less, and even more preferably 45 to 55 parts by mass for 100 parts by mass of thermo-curable binder.

The epoxy compound is not limited as long as it has one or more epoxy groups in its molecules, and can be, e.g., bisphenol A epoxy resin, bisphenol F epoxy resin, and the like or a urethane-modified epoxy resin. Among these, hydrogenated bisphenol A glycidyl ether can be preferably used. A specific example of hydrogenated bisphenol A glycidyl ether is "YX8000 (product name)" manufactured by Mitsubishi Chemical Corporation. The content of the epoxy compound is preferably 30 to 60 parts by mass, more preferably 35 to 55 parts by mass or less, and even more preferably 35 to 45 parts by mass for 100 parts by mass of thermo-curable binder.

As the thermal cationic polymerization initiator, a known thermal cationic polymerization initiator for epoxy compounds can be used, and examples may include an initiator that generates an acid that can cause cationic polymerization of cationic polymerization-type compounds by heat, such as a known iodonium salt, sulfonium salt, phosphonium salt, and ferrocene among others. Among these, aromatic sulfonium salts, which show good latency for temperature, can be used. A specific example of an aromatic sulfonium salt polymerization initiator is "SI-60L (product name)" manufactured by Sanshin Chemical Industry. The content of the thermal cationic polymerization initiator is preferably 1 to 20 parts by mass, more preferably 5 to 15 parts by mass or less, and even more preferably 8 to 12 parts by mass for 100 parts by mass of thermo-curable binder.

In addition, other additives may be blended with the thermo-curable binder as required and examples of the additive may include rubber components, inorganic fillers, silane coupling agents, monomers for dilution, fillers, softeners, colorants, flame retardants, and thixotropic agents, among others.

The rubber component is not particularly limited as long as it is an elastomer having high cushioning (impact-canceling) properties, and specific examples may include acryl rubber, silicone rubber, butadiene rubber, and polyurethane resin (polyurethane elastomer). Examples of the inorganic filler may include silica, talc, titanium oxide, calcium carbonate, and magnesium oxide. One inorganic filler may be used alone or two or more inorganic fillers may be used in combination.

The thermo-curable binder containing such a composition can suppress the curing reaction when forming the individualized pieces using laser light and can be quickly cured by heat during thermocompression bonding.

ANISOTROPIC CONDUCTIVE FILM

In addition, the curable resin film is preferably an anisotropic conductive film that further contains conductive particles. The conductive particles can be selected as appropriate from those used in known anisotropic conductive films. For example, the conductive particles may be metal particles including nickel (melting point: 1,455° C), copper (melting point: 1,085° C), silver (melting point: 961.8° C), gold (melting point: 1,064° C), palladium (melting point: 1,555°C), tin (melting point 231.9°C), nickel boride (melting point 1,230°C), ruthenium (melting point 2,334°C), and solder, which is a tin alloy. In addition, further examples may include metal-coated metal particles, which are metal particles the surface of which is coated with a metal such as nickel, copper, silver, gold, palladium, tin, nickel boride, and ruthenium. In addition, further examples may include metal-coated resin particles, which are resin particles including at least one monomer selected from polyamide, polybenzoguanamine, styrene, and divinylbenzene as a monomer unit and the surface of which is coated with a metal such as nickel, copper, silver, gold, palladium, tin, nickel boride, and ruthenium. In addition, further examples may include metal-coated inorganic particles, which are inorganic particles such as silica, alumina, barium titanate, zirconia, carbon black, silicate glass, borosilicate glass, lead glass, soda-lime glass, and alumina-silicate glass, the surface of which is coated with a metal such as nickel, copper, silver, gold, palladium, tin, nickel boride, and ruthenium. The metal coating layer of the metal-coated resin particles and metal-coated inorganic particles may be a single layer or a multilayer of different metals.

The conductive particles may also be covered with an insulating resin layer or insulating particles such as resin particles and insulating particles to provide an insulating treatment. The particle diameter of the conductive particles in the present invention does not include the insulating layer. The particle diameter of the conductive particles is changed appropriately depending on the areas of the optical elements to be mounted, the electrodes on the wiring substrate, and the bumps, among others, but is preferably 1 to 30 $\mu$m, more preferably 1 to 10 $\mu$m, and particularly preferably 1 to 3 $\mu$m. For example, when used for mounting micro LED elements, since the areas of the electrodes and the bumps are small, the particle diameter of the conductive particles is preferably 1 to 3 $\mu$m, more preferably 1 to 2.5 $\mu$m, particularly preferably 1 to 2.2 $\mu$m. The particle diameter can be determined by measuring the average of 200 or more particles using a microscope (optical microscope, metal microscope, and electron microscope, among others).

In addition, in the cases where the conductive particles are the aforementioned metal-coated resin particles or metal-coated inorganic particles, i.e., resin particles or inorganic particles coated with a metal the thickness of the metal coating is preferably 0.005 $\mu$m or more, more preferably 0.01 $\mu$m or more, and preferably 10 $\mu$m or less, more preferably 1 $\mu$m or less, and even more preferably 0.3 $\mu$m or less. In the cases where the metal coating is multi-layered, this coating thickness is the thickness of the entire metal coating. If the metal coating thickness is above the lower limit and below the upper limit given above, it is easy to obtain sufficient conductivity, and the conductive particles do not become too hard, making it easy to utilize the characteristics of the resin particles and inorganic particles mentioned above.

The metal coating thickness can be measured, e.g., by observing the cross-section of the conductive particle using a transmission electron microscope (TEM). Regarding the above coating thickness, it is preferable to calculate the average of the coating thickness of five arbitrary coating thicknesses as the coating thickness of a single conductive particle, and it is even more preferable to calculate the average of the thickness of the entire coated area as the coating thickness of a single conductive particle. The above coating thickness is preferably obtained by calculating the average of the coating thickness of each of ten arbitrary conductive particles.

In addition, examples of the shape of conductive particles may include spherical, elliptical, spike-shaped, and irregular shapes. Among these, spherical conductive particles are preferred because they are easy to control in terms of particle diameter and particle size distribution. In addition, conductive particles may have protrusions on their front surface to improve connectivity.

The anisotropic conductive film is preferably composed of conductive particles arranged in a surface direction. By arranging conductive particles in a surface direction, the particle areal density becomes uniform, and conductivity and insulation properties can be improved. An example of the state in which conductive particles are arranged in a surface direction is a planar lattice pattern that has one or more array axes on which the conductive particles are arranged in a predetermined direction at a predetermined pitch, including oblique lattices, hexagonal lattices, square lattices, rectangular lattices, and parallelepiped lattices. In addition, the arrangement of conductive particles in a surface direction may be random, and the planar lattice pattern may have multiple regions that differ from each other.

The particle areal density of the anisotropic conductive film can be designed appropriately according to the size of the connection electrode, and the lower limit of the particle areal density can be set to 500 particles/mm$^2$ or more, 20,000 particles/mm$^2$ or more, 40,000 particles/mm$^2$ or more, or 50,000 particles/mm$^2$ or more, and the upper limit of the particle areal density can be set to 1,500,000 particles/mm$^2$ or less, 1,000,000 particles/mm$^2$ or less, 500,000 particles/mm$^2$ or less, or 100,000 particles/mm$^2$ or less. This allows for excellent conductivity and insulation even when the size of the connection electrode is small. The particle areal density of the anisotropic conductive film is the density of the array portion of conductive particles when the film is formed during manufacturing. When calculating the number density of particles from multiple individualized pieces, the particle areal density can be calculated from the area including the individualized pieces and the spaces minus the spaces between individualized pieces, and the number of particles.

The anisotropic conductive film having a film-shape makes it easier to provide the anisotropic conductive film on the base material. From the perspective of handleability, a release film such as polyethylene terephthalate film may be attached to one or both sides of the anisotropic conductive film. In addition, the anisotropic conductive film may be laminated with adhesive layers or pressure-sensitive adhesive layers that do not contain conductive particles, and the number of layers and the laminated surface can be selected as appropriate according to the target and purpose.

The film thickness of the anisotropic conductive film can be changed appropriately depending on the height of the optical elements to be mounted or the electrodes or bumps of a wiring substrate, and should be within 1 to 10 times the particle diameter, preferably 1 $\mu$m or more and 10 $\mu$m or less, more preferably 1 $\mu$m or more and 6 $\mu$m or less, and even more preferably 2 $\mu$m or more and 4 $\mu$m or less. The thickness of the film can be measured using a known micrometer or digital thickness gauge. For example, the thickness can be determined by measuring at least ten points and taking the average.

Examples of the method for manufacturing the anisotropic conductive film may include, e.g., applying a solution of an anisotropic conductive adhesive on a base material and drying the solution, or forming an adhesive layer that does not contain conductive particles on a base material and fixing the conductive particles to the resulting adhesive layer.

## 3. METHOD FOR MANUFACTURING DISPLAY DEVICE

The method for manufacturing a display device in this embodiment includes: a formation step of irradiating a curable resin film formed on a base material with laser light from the base material side to remove the curable resin film in the irradiated area, thereby forming individualized pieces of a predetermined shape composed of the curable resin film on the base material; a transfer step of transferring the individualized pieces of the predetermined shape to a predetermined position on a wiring substrate or to an electrode surface of a light-emitting element; and a mounting step of mounting the light-emitting element to the wiring substrate via the transferred individualized piece. This makes it possible to obtain excellent processability and transferability of the individualized pieces and to reduce the tact time.

The shape of the individualized pieces is formed in correspondence with the shape of the electrodes of the wiring substrate and the light-emitting elements, and as mentioned above, in order to control the workability of the individualized pieces and to suppress the occurrence of curling or chipping when transferring the individualized pieces using LLO, the shape is preferably at least one selected from a polygon with obtuse angles, a polygon with rounded corners, an ellipse, an oval, and a circle. In addition, the curable resin film may be an anisotropic conductive film.

The individualized pieces may be arranged in units of one pixel (e.g., one pixel of an RGB set), i.e., in units of multiple light-emitting elements, or they may be arranged in units of subpixels that constitute one pixel (e.g., any RGB unit), i.e., in units of a light-emitting element. This allows compatibility with both light-emitting element arrays with high PPI (pixels per inch) and light-emitting element arrays with low PPI. In addition, when RGB is composed as a single pixel, for example, three subpixels are arranged as a set, or a total of six subpixels, including three subpixels of redundant RGB circuitry, are arranged as a set, so the individualized pieces may be arranged in units of six subpixels.

The individualized pieces may also be arranged in units of electrodes corresponding to the first conductivity-type electrode on the p-side or the second conductivity-type electrode on the n-side of the light-emitting element, for example. Further, in order to improve productivity, the individualized pieces may also be arranged in a range that will not compromise transparency, such as in units of 1 mm x 1 mm, for example.

In the formation step, the curable resin film may be pre-treated in order to efficiently remove unnecessary portions of the curable resin film. Examples of the pretreatment may include cutting of individualized piece shapes in units of light-emitting elements or electrodes, and grid-shaped cutting made by intersecting multiple vertical cuts and multiple horizontal cuts. The cuts can be made using mechanical, chemical, or laser methods. The cuts do not need to be deep enough to reach the base material and can be half-cuts. This helps to suppress individualized pieces from peeling off.

There are no particular restrictions on the method of transferring individualized pieces in the transfer step, but examples may include the method of directly transferring and arranging individualized pieces from the base material to the wiring substrate or light-emitting element using the laser lift-off method (LLO method) described above, or the method of transferring and arranging individualized pieces from the transfer material to the wiring substrate or light-emitting element using transfer material (stamp material) to which individualized pieces have adhered in advance.

In addition, there are no particular restrictions on the method of arranging light-emitting elements in the mounting step, but the method may include the method of arranging light-emitting elements on a wiring substrate using the laser lift-off method (LLO method) described above, or the method of arranging light-emitting elements on a wiring substrate using a transfer material (stamp material) to which light-emitting elements have adhered in advance.

## FIRST EMBODIMENT

The method for manufacturing a display device according to the first embodiment includes: a formation step (A1) of removing an anisotropic conductive film in the area irradiated by laser light using a laser lift-off device to form individualized pieces of a predetermined shape composed of the anisotropic conductive film on a base material; a transfer step (B1) of transferring the individualized pieces of the predetermined shape to predetermined positions on a wiring substrate using the laser lift-off device; and a mounting step (C1) of arranging the light-emitting elements in predetermined positions on the wiring substrate to mount the light-emitting elements on the wiring substrate using the laser lift-off device.

In the following, the formation step (A1) of forming individualized pieces of a predetermined shape, the transfer step (B1) of transferring the individualized pieces of the predetermined shape, and the mounting step (C1) of mounting the light-emitting element to the wiring substrate will be described with reference to FIGS. 8 to 11.

FORMATION STEP (A1)

In the formation step (A1), an anisotropic conductive film is prepared on a base material, and using the laser lift-off device described above, laser light is irradiated from the base material side, and the removal portion of the anisotropic conductive film is peeled off by the laser light that passes through the opening of the mask described above to form individualized pieces. The method of forming individualized pieces is the same as the method for manufacturing an individualized-piece-film described above, so a detailed explanation is omitted here.

FIG. 8 is a cross-sectional view schematically illustrating the anisotropic conductive film provided on the base material. Here, it is preferable that there is a region X in the thickness direction from the base material 61 side of the anisotropic conductive film 62 where there are no conductive particles. The state where there are no conductive particles in region X means, e.g., not only the state where the entire conductive particle 63 is not present in the region but also the state where even a part of the conductive particle 63 is not present. In other words, it is preferable that all the conductive particles 63 present in the part of the anisotropic conductive film 62 excluding the region X without protruding into the region X.

From the perspective of the productivity of the anisotropic conductive film 62, it is preferable that the number of conductive particles 63 in the region X in the thickness direction from the base material 61 side of the anisotropic conductive film 62 is 5% or less of the total number of conductive particles 63 contained in the anisotropic conductive film 62, and it is more preferable that it is 1% or less.

The film thickness t of the anisotropic conductive film 62 in region X from the base material 61 side may be 0 to 0.05 $\mu$m, and to more reliably suppress degradation of the conductive particles 63 due to ablation, it is preferably 0 to 0.1 $\mu$m, more preferably 0 to 0.15 $\mu$m, and particularly preferably 0 to 0.2 $\mu$m. The area X may be larger than 0.2 $\mu$m. The lower limit is only required to be larger than 0, and this refers to a state in which up to 5% of the total number of conductive particles 63, and preferably up to 1%, have not reached (have not touched) the base material 61. This cross-section can be confirmed by observation using an electron microscope.

Also, from the perspective of improving ablation resistance, it is preferable that the conductive particles 63 include metals with a melting point of 1,400°C or higher. From the perspective of availability, it is preferable that the upper limit of the melting point of the metal is around 3,500°C. Also, from the perspective of availability, the metal that constitutes the conductive particles 63 is preferably to include nickel, palladium, or ruthenium.

Also, when using, the metal-coated resin particles formed by coating the surface of resin particles with a metal or the metal-coated inorganic particles formed by coating the surface of inorganic particles with a metal as the conductive particle 63, in order to minimize the effect of ablation on the resin particles or inorganic particles, it is preferable to make the metal coating thickness 0.04 $\mu$m or more, more preferably 0.5 $\mu$m or more, particularly preferably 0.75 $\mu$m or more, and most preferably 0.1 $\mu$m or more. The upper limit of this metal coating thickness depends on the diameter of the conductive particle 63, but it is preferable to be 20% of the diameter of the conductive particle 63 or about 0.5 $\mu$m.

TRANSFER STEP (B)

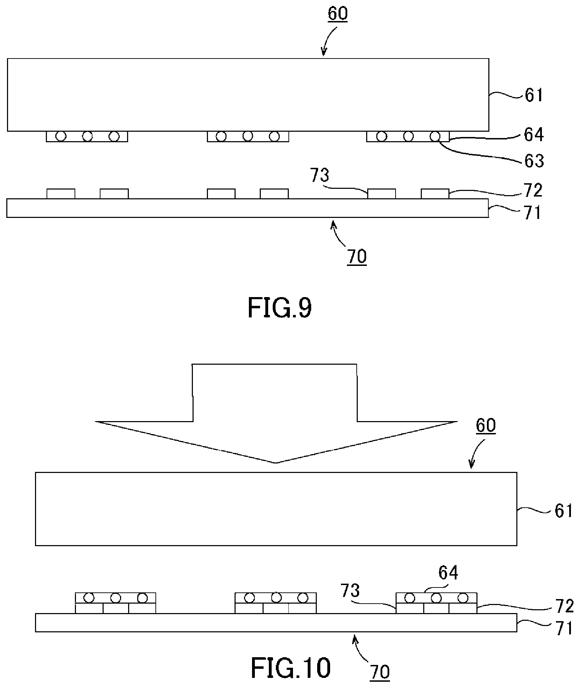

FIG. 9 is a cross-sectional view schematically illustrating a state in which an individualized-piece-film and a wiring substrate face each other. As shown in FIG. 9, in the transfer step (A), the individualized-piece-film 60 and the wiring substrate 70 are brought face to face.

The individualized-piece-film 60 includes the base material 61 and the individualized pieces 64 constituted by anisotropic conductive film containing the conductive particles 63, and the individualized pieces 64 are arranged on the surface of the base material 61 in units of light-emitting elements. The base material 61 is preferably one that is transparent to laser light, and a quartz glass plate, which has a high light transmissivity across the entire wavelength range, is particularly preferable.

The dimensions (vertical dimension x horizontal dimension) of the individualized pieces 64 are set appropriately according to the dimensions of the light-emitting elements, which are chip components, and the ratio of the area of the individualized pieces 64 to the area of the light-emitting elements is preferably 0.5 to 5.0, more preferably 0.5 to 4.0, and even more preferably 0.5 to 2.0. In addition, the thickness of the individualized pieces 64 is preferably 2 to 10 $\mu$m, more preferably 3 to 8 $\mu$m or less, and even more preferably 4 to 6 $\mu$m or less. It is preferable that all the dimensions of the individualized pieces are the same, but in order to increase the design flexibility of the connection structure, there may be multiple types. This makes it possible to obtain a connection structure with excellent light transmissive properties, conductive properties, and insulating properties that could not be achieved with conventional connections using ACP (anisotropic conductive paste), ACF (anisotropic conductive film), NCF (non-conductive film), and adhesives, among others.

In addition, the distance between the individualized pieces arranged on the base material 61 is preferably 3 μm or more, more preferably 5 μm or more, and even more preferably 10 μm or more. The upper limit of the distance between the individualized pieces is preferably 3,000 μm or less, more preferably 1,000 μm or less, and even more preferably 500 μm or less. If the distance between the individualized pieces is too small, it will be difficult to transfer the individualized pieces, and if the distance between the individualized pieces is too large, it will be preferable to paste the individualized pieces. The distance between the individualized pieces can be measured using a microscope (optical microscope, metal microscope, and electron microscope, among others).

The wiring substrate 70 has a first conductivity-type circuit pattern and a second conductivity-type circuit pattern on the base material 71, and has a first electrode 72 and a second electrode 73 in positions corresponding to a first conductivity-type electrode on the p side and a second conductivity-type electrode on the n side, respectively, so that the light-emitting elements are arranged in units of subpixels (sub-pixels) that constitute one pixel. The wiring substrate 70 forms circuit patterns such as data lines and address lines of the matrix wiring, and enables the light-emitting elements corresponding to each subpixel that constitutes one pixel to be turned on and off. A single pixel may be composed of three subpixels, e.g., R (red), G (green), B (blue), four subpixels, e.g., RGBW (white), RGBY (yellow), or two subpixels, e.g., RG, GB.

In addition, when the wiring substrate 70 is used for transparent display applications, it is preferable to be a transparent substrate, and the base material 71 is preferably glass or PET (polyethylene terephthalate). The first electrode 72 and the second electrode 73 are preferably transparent conductive films such as ITO (Indium-Tin-Oxide), IZO (Indium-Zinc-Oxide), ZnO (Zinc-Oxide), and IGZO (Indium-Gallium-Zinc-Oxide).

FIG. 10 is a cross-sectional view schematically illustrating a state in which the individualized pieces of an anisotropic conductive film are transferred to and arranged in predetermined positions on the wiring substrate by irradiating laser light from the base material side. As shown in FIG. 10, in the transfer step (B), the laser lift-off device described above is used to irradiate laser light from the base material 61 side and transfer and arrange the individualized pieces 64 of an anisotropic conductive film to/in predetermined positions on the wiring substrate 70. By aligning the base material 61 and the substrate 70 and transferring the material, it is possible to arrange the individualized pieces 64 on the substrate 70 in units of subpixels.

If the size of the base material 61 is larger than the size of the substrate 70, the individualized pieces 64 can be arranged in the screen region of the substrate 70 in units of subpixels by aligning the base material 61 and transferring the individualized pieces 64 multiple times.

The laser lift-off device described above can be used to transfer the individualized pieces 64 of the anisotropic conductive film. This transfer method is called laser lift-off, and for example, it is a method that uses laser ablation. In the laser lift-off device described above, the individualized-piece-film 60, which is the donor substrate, is held on the donor stage, and the wiring substrate 70, which is the receptor substrate, is held on the receptor stage. The distance between the individualized-piece-film and the wiring substrate is preferably 10 to 20,000 μm, more preferably 50 to 1,500 μm, and even more preferably 80 to 1,000 μm.

As a laser device, e.g., an excimer laser that oscillates laser light with a wavelength of 180 nm to 360 nm can be used. The oscillation wavelengths of excimer lasers are, e.g., 193, 248, 308, and 351 nm, and an appropriate oscillation wavelength can be selected from these according to the light absorption properties of the material of the anisotropic conductive film.

The mask had a pattern with an array of windows of a predetermined size and pitch so that the projection at the interface between the base material 61 and the individualized pieces 64 of the anisotropic conductive film forms the desired arrangement of laser light. The mask has a pattern applied to the base material 61 using chrome plating, e.g., the window areas that are not chrome-plated are transparent to laser light, while the chrome-plated areas block laser light.

The incident light from the laser device enters the telescope optics and is transmitted to the laser scanner 11. The laser light just before entering the laser scanner 11 is adjusted by the telescope optics so that it becomes roughly parallel light at any position within the movement range of the X-axis and Y-axis of the donor stage, and it enters the laser scanner 11 at roughly the same size and the same angle (perpendicular).

The laser light that passes through the laser scanner 11 passes through the field lens and enters the mask 12, and the laser light that passes through the pattern of the mask 12 enters the projection lens 13. The laser light emitted from the projection lens 13 enters from the base material 61 side and is accurately projected onto the position of the individualized piece 64 of the anisotropic conductive film formed on a surface (bottom surface) of the base material at a reduced size of the mask pattern.

The pulse energy of the laser light that is irradiated to and imaged at the interface between the individualized piece of the anisotropic conductive film and the base material is preferably 0.001 to 2J, more preferably 0.01 to 1.5J, and even more preferably 0.1 to 1J. The fluence is preferably 0.001 to 2 J/cm$^2$, more preferably 0.01 to 1 J/cm$^2$, and even more preferably 0.05 to 0.5 J/cm$^2$. The pulse width (irradiation time) is preferably 0.01 to 1 x 10$^9$ picoseconds, more preferably 0.1 to 1 x 10$^7$ picoseconds, and even more preferably 1 to 1 x 10$^5$ picoseconds. The pulse frequency is preferably 0.1 to 10,000 Hz, more preferably 1 to 1,000 Hz, and even more preferably 1 to 100 Hz. The number of irradiation pulses is preferably between 1 and 30,000,000.

Such a laser lift-off device can generate an impact wave in the individualized piece 64 that has been irradiated with laser light at the interface between the base material 61 and the individualized piece 64 of the anisotropic conductive film, lift the individualized piece 64 away from the base material 61 and towards the wiring substrate 70, and cause multiple individualized pieces 64 to land at predetermined positions on the wiring substrate 70. This makes it possible to transfer and arrange the individualized pieces 64 of an anisotropic conductive film to/on the wiring substrate 70 with high accuracy and efficiency to reduce the tact time.

The reaction rate of the individualized pieces 64 of an anisotropic conductive film after the transfer step (B1) is preferably 25% or less, more preferably 20% or less, and even more preferably 15% or less. The reaction rate of the individualized pieces 64 after the transfer step (B1) being 25% or less makes it possible to thermocompression-bond the light-emitting elements in the mounting step (C1). The reaction rate can be measured using, e.g., FT-IR.

In addition, as with the distance between the individualized pieces arranged on the base material 61 of the individualized-piece-film 60, the distance between the individualized pieces arranged in the predetermined position on the wiring substrate 70 is preferably 3 $\mu$m or more, more preferably 5 $\mu$m or more, and even more preferably 10 $\mu$m or more. The upper limit of the distance between the individualized pieces is preferably 3,000 $\mu$m or less, more preferably 1,000 $\mu$m or less, and even more preferably 500 $\mu$m or less. If the distance between the individualized pieces is too small, it will be preferable to paste the anisotropic conductive film to the entire surface of the wiring substrate 70, and if the distance between the individualized pieces is too large, it will be preferable to paste the anisotropic conductive film to the predetermined position of the wiring substrate 70. The distance between the individualized pieces can be measured using a microscope (optical microscope, metal microscope, and electron microscope, among others).

MOUNTING STEP (C1)

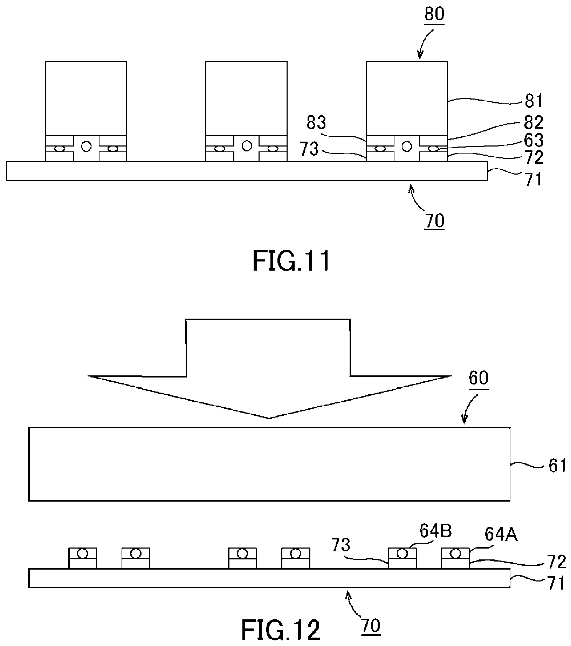

FIG. 11 is a cross-sectional view schematically illustrating a state in which light-emitting elements are mounted on the individualized pieces arranged in predetermined positions on the wiring substrate. As shown in FIG. 11, in the mounting step (C1), the light-emitting element 80 is mounted on the individualized piece 64 arranged in the predetermined position on the wiring substrate 70.

The light-emitting element 80 has a main body 81, a first conductivity-type electrode 82, and a second conductivity-type electrode 83, and has a horizontal structure in which the first conductivity-type electrode 82 and the second conductivity-type electrode 83 are arranged on the same side. The main body 81 has a so-called double heterostructure, including a first conductivity-type cladding layer made of, e.g., n-GaN, an active layer made of, e.g., $In_xAl_yGa_{1-x-y}N$ layers, and a second conductivity-type cladding layer made of, e.g., p-GaN. The first conductivity-type electrode 82 is formed in part of the first conductivity-type cladding layer by a passivation layer, and the second conductivity-type electrode 83 is formed in part of the second conductivity-type cladding layer. When a voltage is applied between the first conductivity-type electrode 82 and the second conductivity-type electrode 83, carriers are concentrated in the active layer and recombined, resulting in light emission.

The light-emitting elements 80 are arranged on the substrate 70 in correspondence with each subpixel that constitutes a single pixel, to form a light-emitting element array. A single pixel may be composed of three subpixels, e.g., R (red), G (green), B (blue), four subpixels, e.g., RGBW (white), RGBY (yellow), or two subpixels, e.g., RG, GB.

Examples of the arrangement of subpixels may include, in the case of RGB, stripe arrangement, mosaic arrangement, and delta arrangement, among others. The stripe arrangement is one in which RGB is arranged in a vertical stripe pattern, and this arrangement can achieve high resolution. In addition, the mosaic arrangement is one in which the same color of RGB is arranged diagonally, and a more natural image can be achieved than with the stripe arrangement. In addition, the delta arrangement is one in which RGB is arranged in a triangular pattern, and each dot is offset by half a pitch for each field, and a natural image display can be achieved.

In the mounting step (C1), the light-emitting element 80 can be placed in the predetermined position on the wiring substrate 70 using the laser lift-off device described above. In the aforementioned laser lift-off device, the light-emitting element, which is the donor substrate, is held on the donor stage, and the wiring substrate 70, which is the receptor substrate, is held on the receptor stage. The distance between the light-emitting element and the wiring substrate is preferably 10 to 1,000 $\mu$m, more preferably 50 to 500 $\mu$m, and even more preferably 80 to 200 $\mu$m.

As a method for connecting the light-emitting element 80 to the wiring substrate 70, a connection method such as thermocompression bonding, photocompression bonding, or thermophotocompression bonding, which is used in a known anisotropic conductive film, can be selected and used as appropriate. In the case where the conductive particles are solder particles, they may be connected by reflow. The conditions for thermocompression bonding are, e.g., a temperature of 150°C to 260°C, a pressure of 1 MPa to 60 MPa, and a time of 5 seconds to 300 seconds. By curing the anisotropic conductive film, a cured film is formed, and the light-emitting elements 80 can be anisotropically connected to the wiring substrate 70 in a state where the wiring substrate 70 is exposed without the presence of the cured film between the light-emitting elements 80. In addition, by making the wiring substrate 70 a transparent substrate, superior light transmissive properties can be obtained compared to when the entire surface of the wiring substrate 70 is covered with the anisotropic conductive film.

MODIFICATION OF FIRST EMBODIMENT

In the transfer step (B1) of the first embodiment described above, as shown in FIGS. 9 and 10, the individualized pieces 64 of the anisotropic conductive film are arranged on the wiring substrate 70 in units of subpixels, which are units of light-emitting elements, but the arrangement is not limited to this, and for example, they may be arranged in units of electrodes corresponding to the first conductivity-type electrode on the p side or the second conductivity-type electrode on the n side of the light-emitting element.

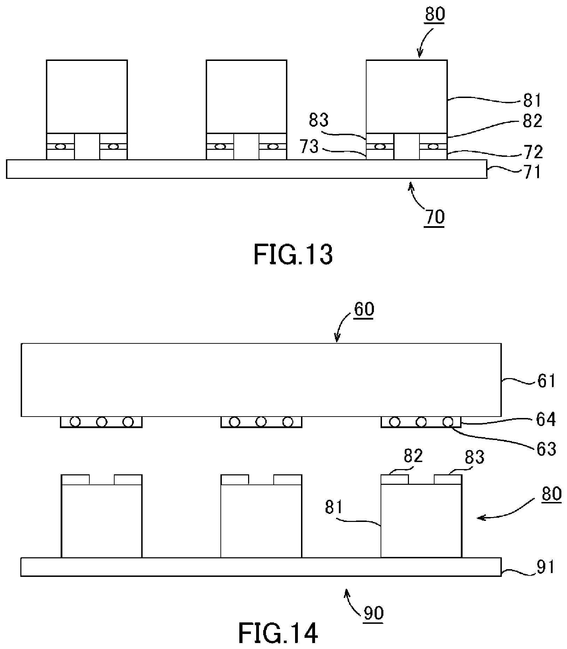

FIG. 12 is a cross-sectional view schematically illustrating a state in which the individualized pieces of an anisotropic conductive film are transferred to and arranged in the electrode position of the wiring substrate by irradiating laser light from the base material side, and FIG. 13 is a cross-sectional view schematically illustrating a state in which light-emitting elements are mounted on the individualized pieces arranged on the wiring substrate in units of electrodes. As shown in FIG. 12, in the transfer step (B1), the first individualized piece 64A and the second individualized piece 64B are transferred to, e.g., the first electrode 72 and the second electrode 73 respectively corresponding to the first conductivity-type electrode 82 on the p-side and the second conductivity-type electrode 83 on the n-side of the light-emitting element 80.

The dimensions (vertical dimension x horizontal dimension) of the individualized pieces 64A, 64B are set appropriately according to the dimensions of the electrodes of the light-emitting elements, and as in the case of forming the individualized pieces in units of electrodes, the ratio of the area of the individualized pieces to the area of the electrodes is preferably 0.5 to 5.0, more preferably 0.5 to 4.0, and even more preferably 0.5 to 2.0. The thickness of the individualized pieces is preferably 2 to 10 $\mu$m, more preferably 3 to 8 $\mu$m, and even more preferably 4 to 6 $\mu$m or less.

As shown in FIG. 13, in the mounting step (C1), the light-emitting elements 80 are mounted on the individualized pieces 64A, 64B arranged in units of electrodes on the wiring substrate 70. This allows the transparency of the display device to be further improved.

As explained above, the method for manufacturing a display device in the first embodiment allows the individualized pieces 64 of the anisotropic conductive film to be transferred to and arranged on the wiring substrate 70 with high accuracy and efficiency by irradiating laser light, thereby reducing the tact time. In addition, it is possible to obtain excellent light transmissive properties, conductive properties, and insulating properties that could not be achieved with conventional connections using ACP, ACF, NCF, or adhesive, thereby enabling the production of high-luminance, high-definition transparent displays.

SECOND EMBODIMENT

The method for manufacturing a display device according to the second embodiment includes: a formation step (A2) of removing an anisotropic conductive film in the area irradiated by laser light using a laser lift-off device to form individualized pieces of a predetermined shape composed of the anisotropic conductive film on a base material; a transfer step (B2-1) of transferring the individualized pieces of the predetermined shape to the electrode surface of the light-emitting element using a laser lift-off device; retransfer step (B2-2) of retransferring the light-emitting elements to which the individualized pieces have been transferred to a predetermined position on the circuit board using a laser lift-off device; and a mounting step (C2) of mounting the light-emitting element on the wiring substrate. This makes it possible to obtain excellent processability and transferability of the individualized pieces and to reduce the tact time.

In the following, the formation step (A2) of forming individualized pieces of a predetermined shape, the transfer step (B2-1) of transferring the individualized pieces of the predetermined shape to the electrode surface of the light-emitting element, the retransfer step (B2-2) of retransferring the light-emitting element with the individualized piece to a predetermined position on the substrate, and the mounting step (C2) of mounting the light-emitting element on the substrate will be described with reference to FIGS. 14 to 16. The same symbols are used for the same components as in the first embodiment, and the description thereof is omitted.

FORMATION STEP (A2)

The formation step (A2) is the same as the formation step (A1) in the first embodiment, so the detailed description thereof is omitted here.

TRANSFER STEP (B2-1)

FIG. 14 is a cross-sectional view schematically illustrating a state in which individualized pieces of an anisotropic conductive film provided on the base material and light-emitting elements arranged on the transfer substrate face each other. As shown in FIG. 14, in the transfer step (B2), the individualized pieces 64 of the anisotropic conductive film provided on the base material 61 and the transfer substrate 90 are brought face to face. The individualized piece 64 is formed on the base material 61 in correspondence with the shape of the electrode of light-emitting element 50.

The transfer substrate 90 includes a base material 91 and light-emitting elements 80 arranged on the base material 91. The base material 91 is selected appropriately according to the transfer method used in the retransfer step (B2-2) described later. For example, if the transfer method using laser ablation is used in the retransfer step (B2-2) described later, the base material 91 only needs to be transparent to laser light, and quartz glass, which has a high light transmissivity across the entire wavelength range, is particularly preferable. Furthermore, for example, in the retransfer step (B2-2) described later, when the transfer substrate 90 is pasted to the wiring substrate 20 to transfer the light-emitting element 80, the base material 91 may have a silicone rubber layer.

In the transfer step (B2-1), a transfer method using laser ablation, called laser lift-off, can be used in the same way as the first embodiment described above.

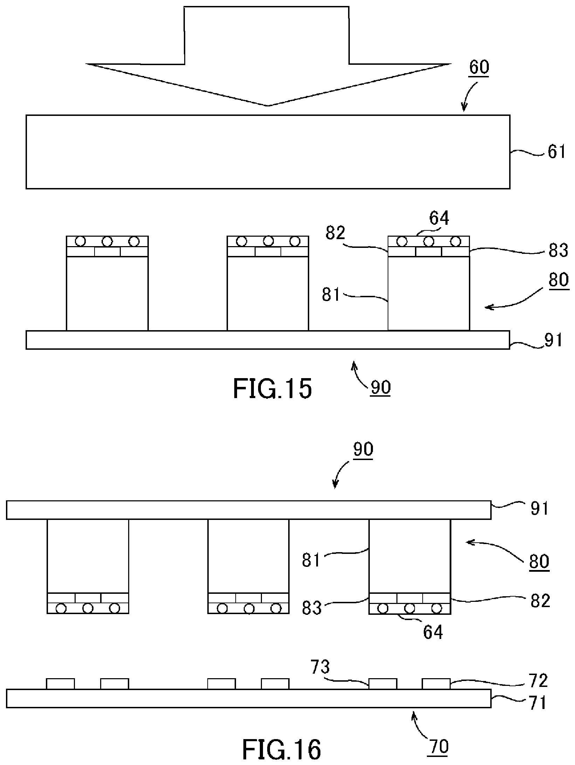

FIG. 15 is a cross-sectional view schematically illustrating a state in which individualized pieces of an anisotropic conductive film are transferred to light-emitting elements arranged on the transfer substrate by irradiating laser light from the base material side. As shown in FIG. 15, in the transfer step (B2-1), laser light is irradiated from the base material 61 side to transfer the individualized pieces 64 of the anisotropic conductive film onto the light-emitting elements 80 arranged on the transfer substrate 90.

As with the first embodiment described above, the laser lift-off device described above can be used to transfer the individualized pieces 64 of the anisotropic conductive film. Such a laser lift-off device can generate an impact wave in the individualized piece 64 that has been irradiated with laser light at the interface between the base material 61 and the individualized piece 64 of the anisotropic conductive film, lift the multiple individualized pieces 64 away from the base material 61 and towards the light-emitting element 80 arranged on the transfer substrate, and cause individualized pieces 64 to land on the light-emitting elements 80 with high accuracy.

RETRANSFER STEP (B2-2)

FIG. 16 is a cross-sectional view schematically illustrating a state in which light-emitting elements to which the individualized pieces have been transferred are retransferred to a wiring substrate. As shown in FIG. 16, in the retransfer step (B2-2), the light-emitting elements 80 to which the individualized pieces 64 have been transferred are retransferred onto the wiring substrate 70. There are no particular restrictions on the method of retransferring, but for example, the light-emitting element 80 to which the individualized pieces 64 have been transferred may be directly transferred from the transfer substrate 90 to the wiring substrate 70 and arranged on the wiring substrate 70 using the laser lift-off (LLO) method, or the light-emitting element 80 may be transferred to and arranged on the wiring substrate 70 from the transfer substrate 90 to which the light-emitting element 80 to which the individualized pieces 64 have been transferred is adhered in advance.

In the retransfer step (B2-2), it is preferable to transfer the light-emitting elements 80 in units of subpixels that constitute a single pixel. This allows compatibility with both light-emitting element arrays with high PPI (pixels per inch) and light-emitting element arrays with low PPI.

MOUNTING STEP (C2)

In the mounting step (C2), the light-emitting elements 80 arranged in predetermined positions on the wiring substrate 70 are mounted via the individualized pieces 64. The state of the light-emitting elements 80 mounted is the same as the first embodiment shown in FIG. 11. The connection method of the light-emitting elements 80 to the wiring substrate 70 is the same as the first embodiment. This allows the light-emitting elements 80 to be anisotropically connected on the wiring substrate 70 in a state where the wiring substrate 70 is exposed without the presence of the anisotropic conductive film between the light-emitting elements 80. In addition, by making the wiring substrate 70 a transparent substrate, superior light transmissive properties can be obtained compared to when the entire surface of the wiring substrate 70 is covered with the anisotropic conductive film.

MODIFICATION OF SECOND EMBODIMENT

In the transfer step (B2-1) of the second embodiment described above, as shown in FIGS. 14 and 15, the individualized pieces 64 of the anisotropic conductive film are transferred onto the light-emitting element 80, but the transfer is not limited to this, and for example, the individualized pieces of the anisotropic conductive film may be transferred onto the light-emitting element in units of electrodes. In other words, as in the modification of the first embodiment shown in FIG. 13, the first individualized pieces and the second individualized pieces can be transferred and mounted on the first conductivity-type electrode 82 on the p-side and the second conductivity-type electrode 83 on the n-side of the light-emitting element 80, respectively. This allows the transparency of the display device to be further improved.

As explained above, the manufacturing method for the display device in the second embodiment allows the individualized pieces 64 of an anisotropic conductive film to be transferred and arranged on the light-emitting element 80 with high accuracy and efficiency through the irradiation of laser light, thereby reducing the tact time. In addition, it is possible to obtain excellent light transmissive properties, conductive properties, and insulation properties that could not be achieved with conventional connections using ACP, ACF, NCF, or adhesive provided on the entire surface, thereby enabling the production of high-luminance, high-definition transparent displays.

REPAIR STEP

In the display device according to the aforementioned embodiment, e.g., if there is a light-emitting element that is not lighting up, a repair step can be performed by removing the light-emitting element that is not lighting up using the aforementioned laser lift-off device, and then transferring an individualized piece of the curable resin film to the relevant portion and mounting the light-emitting element. In the laser lift-off device, a display device having a wiring substrate on which light-emitting elements are arranged is held on the donor stage, the desired light-emitting elements and individualized pieces are peeled off by irradiating laser light from the base material side, and the light-emitting elements and individualized pieces peeled off from the wiring substrate are received by the receptor substrate. In this embodiment, the wiring substrate is exposed between the individualized pieces, so it is preferable to perform repair on an individualized piece basis.

In addition, the aforementioned embodiment gave an example of a method for manufacturing a display device as a display, but the present technology is not limited to this, and can also be applied to a method for manufacturing a light-emitting device as a light source, for example.

4. DISPLAY DEVICE

The display device according to the present embodiment can be obtained by the method for manufacturing a display device described above. That is, the display device includes a plurality of light-emitting elements, a wiring substrate on which the light-emitting elements are arranged, and a cured film that connects the light-emitting elements and the wiring substrate, and the cured film is made by curing individualized pieces of a predetermined shape composed of a curable resin film.

The shape of the individualized pieces is preferably at least one selected from a polygon with obtuse angles, a polygon with rounded corners, an ellipse, an oval, and a circle. This allows the substrate to be exposed between the individualized pieces, and provides excellent light transmissive properties and a pleasing appearance.

As shown in the aforementioned FIGS. 11 and 13, the display device includes the plurality of light-emitting elements 80, the substrate 70 on which the light-emitting elements 80 are arranged, and the cured film that connects the plurality of light-emitting elements 80 to the substrate 70.

The cured film is a cured piece of curable resin film of a predetermined shape. The arrangement of the individualized pieces on the substrate 70 is not particularly limited as long as a light transmissive property is achieved, but it is preferable that it is in units of subpixels corresponding to the light-emitting elements 80. By arranging the individualized pieces in units of subpixels, the exposed portions of the substrate between the individualized pieces can be increased, and an excellent light transmissive property can be achieved. In addition, multiple light-emitting elements 80 in close proximity in units of subpixels can be connected with a single individualized pieces. This can reduce the mounting speed (increase the mounting efficiency), and also expand the range of acceptable specifications depending on the transparency and color tone of the base material side.

In addition, the individualized pieces made of cured film are preferably cured films of adhesive film, conductive film containing conductive particles, or anisotropic conductive film. This makes it possible to connect multiple light-emitting elements 80 to the substrate 70 even when the light-emitting elements 80 do not have solder bumps or other connection points. In addition, if the electrodes of the light-emitting elements 80 are in the form of, e.g., protrusions, and electrical connections can be achieved with the wiring of the substrate 70, the individualized pieces do not need to contain conductive particles.

The cured film of the anisotropic conductive film is preferably composed of conductive particles arranged in a surface direction. By arranging conductive particles in a surface direction, the particle areal density becomes uniform, and conductivity and insulation properties can be improved. An example of the state in which conductive particles are arranged in a surface direction is a planar lattice pattern that has one or more array axes on which the conductive particles are arranged in a predetermined direction at a predetermined pitch, including oblique lattices, hexagonal lattices, square lattices, rectangular lattices, and parallelepiped lattices. In addition, the arrangement of conductive particles in a surface direction may be random, and the planar lattice pattern may have multiple regions that differ from each other.

The particle areal density of the cured film of the anisotropic conductive film can be designed appropriately according to the size of the electrodes of the light-emitting element 80, and the lower limit of the particle areal density can be set to 500 particles/mm$^2$ or more, 20,000 particles/mm$^2$ or more, 40,000 particles/mm$^2$ or more, or 50,000 particles/mm$^2$ or more, and the upper limit of the particle areal density can be set to 1,500,000 particles/mm$^2$ or less, 1,000,000 particles/mm$^2$ or less, 500,000 particles/mm$^2$ or less, or 100,000 particles/mm$^2$ or less. This allows for excellent conductivity and insulation even when the electrodes of the light-emitting element 80 are small.

The particle areal density of the cured film of the anisotropic conductive film is the density of the conductive particles when the film is formed during manufacturing. This is the same whether the measurement is of randomly arranged particles or of particles arranged in a pattern. When calculating the number density of particles from multiple individualized pieces, the particle areal density can be calculated from the area including the individualized pieces and the spaces minus the spaces between individualized pieces, and the number of particles. In some cases, it is not appropriate to express the individualized pieces in terms of the number density, and it may be more appropriate to express it in terms of the area occupied by the particles in a single individualized piece, or the particle diameter, the distance between the centers of the particles, and the number of particles.

The particle areal density of the cured film of the anisotropic conductive film is the density of the conductive particles when the film is formed during manufacturing. This is the same whether the measurement is of randomly arranged particles or of particles arranged in a pattern. When calculating the number density of particles from multiple individualized pieces, the particle areal density can be calculated from the area including the individualized pieces and the spaces minus the spaces between individualized pieces, and the number of particles. In some cases, it is not appropriate to express the individualized pieces in terms of the number density, and it may be more appropriate to express it in terms of the area occupied by the particles in a single individualized piece, or the particle diameter, the distance between the centers of the particles, and the number of particles.

The number of conductive particles per individualized piece can be designed appropriately according to the electrode size of the light-emitting element 80, and the lower limit is, e.g., 2 or more, preferably 4 or more, and more preferably 10 or more, and the upper limit is 6,000 or less, preferably 500 or less, and more preferably 100 or less.

The average transmittance of visible light after the individualized pieces are placed (provided) on the substrate is preferably 20% or more, more preferably 35% or more, and even more preferably 50% or more. This makes it possible to obtain a display device with excellent light transmissive properties and a good appearance. Even if the substrate is not transparent, the average transmittance can be obtained by attaching the individualized pieces to a plain glass plate or a transparent substrate for evaluation and using these as a reference (Ref). The average transmittance of visible light with light-emitting elements attached will be lower. In a case where a light-emitting element is mounted, the measurement is taken when the light-emitting element is not lit. The average transmittance of visible light can be measured using a UV-visible spectrophotometer, for example.

The size of the individualized piece may be smaller than the size of the light-emitting element 80, as long as conductivity is achieved. In addition, the individualized pieces may be located so that they present not only directly below the light-emitting element but also in the peripheral edge portion, as long as the light transmissive property of the display device is achieved.

The amount of protrusion of the individualized pieces from the light-emitting element 80 is preferably less than 30 μm, more preferably less than 10 μm, and even more preferably less than 5 μm. In addition, if the individualized pieces do not protrude, the amount of protrusion may be zero or even negative. This allows for superior light transmittance compared to configuration examples of display devices with a cured film on the entire surface of the substrate. The amount of protrusion of the individualized pieces from the light-emitting element 80 is the maximum value of the distance between the peripheral edge portion of the light-emitting element 80 and the peripheral edge portion of the individualized piece.

According to the display device of this embodiment, having an exposed portion where the substrate 70 is exposed between the individualized pieces of the cured film, it is possible to obtain excellent light transmissive properties, conductive properties, and insulation properties that could not be achieved with conventional connections using ACP, ACF, NCF, or adhesive provided on the entire surface, thereby enabling the production of high-luminance, high-definition transparent displays.

The above-mentioned embodiment gave an example of a display device in which light-emitting elements 80 are arranged in units of subpixels, but the present technology is not limited to this, and can also be applied to a light-emitting device as a light source, for example. The light-emitting device includes a plurality of light-emitting elements, a substrate on which the light-emitting elements are arranged, and a cured film that connects the light-emitting elements to the substrate, and the cured film is composed of a plurality of individualized pieces and has an exposed portion in which the substrate is exposed between the individualized pieces. With such a light-emitting device, the available number of chips per wafer can be increased by making the light-emitting elements 80 smaller, which makes it possible to reduce the price, and it also has industrial advantages such as making the light-emitting device thinner and more energy efficient.

The above explanation describes, as a part of the suitable embodiment of the present technology, the formation step of irradiating a curable resin film formed on a base material with laser light from the base material side to remove the curable resin film in the irradiated area, thereby forming individualized pieces of a predetermined shape composed of the curable resin film with a reaction rate of 25% or less on the base material.

Here, the removal of the curable resin film by irradiating laser light does not only mean complete peeling or removal of the curable resin film but also includes partial peeling or removal of the curable resin film.

In addition, it is not necessarily removal, and it may be an alteration of the curable resin film (e.g., curing, softening, or the like) by irradiating laser light that facilitates efficient transfer in the subsequent transfer step of the individualized piece. Of course, removal and alteration can be combined.

The individualized pieces of the predetermined shape formed on the base material do not necessarily have to be a curable resin film with a reaction rate of 25% or less but can be any desired resin film. The desired resin film may include, e.g., a curable resin film with a reaction rate of over 25%, and a non-curable resin film such as a thermoplastic resin film. It can also be a cured film made by curing a resin film.

EXAMPLES

5. EXAMPLES

In the examples, the anisotropic conductive films were processed into individualized pieces and the shape and states of the individualized pieces were evaluated. In addition, the individualized pieces were also transferred to a glass plate and the transfer state of the individualized pieces was evaluated. It should be noted that the present technology is not limited to these examples.

The fabrication of the anisotropic conductive film substrate, the evaluation of the individualization process, and the evaluation of the individualized piece transfer were carried out as follows.

FABRICATION OF ANISOTROPIC CONDUCTIVE FILM SUBSTRATE

First, 42 parts by mass of phenoxy resin (product name: PKHH, manufactured by Tomoe Engineering), 40 parts by mass of high-purity bisphenol A type epoxy resin (product name: YL-980, manufactured by Mitsubishi Chemical Corporation), 10 parts by mass of hydrophobic silica (product name: R202, manufactured by NIPPON AEROSIL), 3 parts by mass of acrylic rubber (product name: SG80H, manufactured by Nagase ChemteX Corporation), and 5 parts by mass of cationic polymerization initiator (product name: SI-60L, manufactured by Sanshin Chemical Industry) were blended, applied to a 4-inch quartz glass plate, and dried to prepare a resin film.

Conductive particles (average particle diameter $2.2\mu$m, resin core conductive fine particles, Ni plating $0.2\mu$m thick, manufactured by Sekisui Chemical) were pressed into the resulting resin film according to the method described in JP 6187665 B so that the interface of one side of the resin film and the conductive particles were almost aligned to prepare anisotropic conductive film substrate in which an anisotropic conductive film with $4.0\,\mu$ m thick and a particle areal density of 580,000 pcs/mm$^2$ is provided on the 4-inch quartz glass plate. The alignment of the conductive particles in the plane view of the anisotropic conductive film was made to be a hexagonal lattice arrangement.

EVALUATION OF INDIVIDUALIZATION PROCESS NON-DEFECTIVE RATE OF SHAPE

After the anisotropic conductive film was processed into individualized pieces, 1,000 pcs were selected at random from the individualized pieces (total of 10,000 pcs), and individualized pieces with a non-defective shape (without curling or chipping) were visually counted under a microscope (for curling or chipping, see the individualized pieces 42 in which curling occurs or the individualized pieces 43 in which chipping occurs in FIG. 4 (B) described above). The non-defective rate of the shape was then calculated using the following formula. The non-defective rate is preferably 95% or more.

non-defective rate = number of non-defective individualized pieces / total number x 100

BURR OCCURRING RATE

After processing the anisotropic conductive film into individualized pieces, the number of burrs was counted for all the individualized pieces (total of 10,000 pcs), and the shape non-defective rate was calculated using the following formula (for burrs, see the individualized pieces 41 in FIG. 4 (A) in which burrs occur). The number of burrs should be 10% or less.

burr occurring rate = number of burrs / total number of individualized pieces x 100

REACTION RATE

The reaction rate of the individualized pieces was measured using FT-IR (Varian 3100 FT-IR (Excalibur Series) Microscope Varian 600 UMA (FT-IR Microscope)). First, after laser irradiation, the individualized pieces remaining on the substrate were sampled using a pen-type cutter with a sharp tip, and the samples after laser irradiation were obtained. Next, using a set of two diamond cells, the sample was sandwiched between two cell plates and compressed, and then the sample was measured using one of the cell plates with the sample attached.

Detector sensitivity is greatly improved by cooling, so the detector is cooled with liquid nitrogen for approximately 30 minutes prior to measurement. The FT-IR measurement conditions were set as follows.

Measurement method: transmission type measurement
Measurement temperature: 25°C
Measurement humidity: 60% or less
Measurement time: 12 sec
Spectral range of detector: 4,000 to 700 cm$^{-1}$

Then, the diamond cell was set up in the infrared microscope, background measurements were taken, and the sample after laser irradiation was irradiated with infrared light to obtain the IR spectrum of the individualized pieces remaining on the substrate after the laser irradiation. In the same way as the above sample after laser irradiation, the curable resin film before laser irradiation (before individualization) was sampled using a pen-type cutter with a sharp tip to obtain the IR spectrum of the curable resin film before laser irradiation. The reaction rate was calculated by measuring the peak height of the methyl group (around 2,930 cm$^{-1}$) and the epoxy group (around 914 cm$^{-1}$) in the IR spectrum, and then calculating the ratio of the peak height of the epoxy group to the peak height of the methyl group before and after the reaction (before and after laser irradiation), as shown in the following formula. The reaction rate is preferably 25% or less.

$$\text{reaction rate } (\%) = \{1 - (a / b) / (A / B)\} \times 100$$

In the above formula, A is the peak height of the epoxy group before the reaction, B is the peak height of the methyl group before the reaction, a is the peak height of the epoxy group after the reaction, and b is the peak height of the methyl group after the reaction.

EVALUATION OF INDIVIDUALIZED PIECE TRANSFER

Using a laser lift-off device (LUM-XTR manufactured by Shin-Etsu Engineering), 1,000 pcs of individualized pieces of an anisotropic conductive film were transferred to a glass substrate. As shown in the aforementioned FIG. 1, an example of the laser lift-off device includes: a laser scanner that scans the optical axis of the laser light; a mask having multiple openings of a predetermined shape arranged at a predetermined pitch; a projection lens that reduces and projects the laser light onto the donor substrate; a donor stage that holds the donor substrate; and a receptor stage that holds the receptor substrate, wherein a quartz glass substrate on which individualized pieces are formed is held on a donor stage, a glass substrate is held on the receptor stage, and the distance between the individualized piece and the glass substrate is set to 100 μm.

The laser device used an excimer laser with an oscillation wavelength of 248 nm. The pulse energy of the laser light was 600J, the fluence was 180 J/cm$^2$, the pulse width (irradiation time) was 30,000 picoseconds, the pulse frequency was 0.01 kHz, and the number of irradiation pulses was 1 pulse per individualized piece.

The pulse energy of the laser light irradiated and imaged at the interface between the individualized piece of anisotropic conductive film and the quartz glass plate was 0.001 to 2J, the fluence (fluence) was 0.001 to 2 J/cm$^2$, the pulse width (irradiation time) was 0.01 to 1x 10$^9$ picoseconds, the pulse frequency was 0.1 to 10,000 Hz, and the number of irradiated pulses was 1 to 30,000,000.

The mask used a pattern with an array of predetermined-sized windows at a predetermined pitch, so that the projection at the interface between the individualized pieces of anisotropic conductive film, which is the donor substrate, and the quartz glass plate would be the size of the individualized pieces with a pitch of 120 μm (horizontal) and 160 μm (vertical) (30 μm (horizontal) x 40 μm (vertical), or 60 μm (horizontal) x 80 μm (vertical)). While aiming the laser light at the openings of the mask and scanning the optical axis of the laser light in the X and Y directions, the pulse irradiation of the laser light was controlled to transfer the individualized pieces onto the glass substrate of the receptor stage.

NON-DEFECTIVE PRODUCT RATE

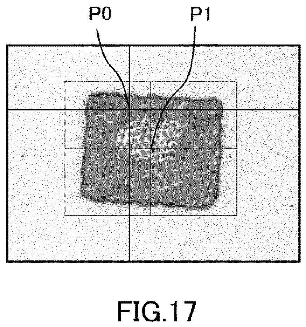

The 1,000 pcs of the individualized piece transferred to the glass substrate were observed under a microscope, and the pieces with good transfer shape and good transfer were counted, and the non-defective product rate of the individualized pieces was calculated using the following formula. The non-defective product rate should be 85% or more. In addition, good transfer shape means that there is no curling or chipping (for curling or chipping, see the individualized pieces 42 in which curling occurs or the individualized pieces 43 in which chipping occurs in FIG. 4 (B) described above). In addition, good transfer means that the transfer has been performed at the specified location (see the position of the individualized pieces before and after transfer in FIG. 17 described later).

non-defective product rate = number of products with good transfer / total number x 100

TRANSFER POSITION ACCURACY

Using a laser lift-off device (LUM-XTR manufactured by Shin-Etsu Engineering), 1,000 pcs of individualized pieces were transferred 25 times from a quartz glass plate to a quartz glass plate, and the amount of positional deviation that occurred after transfer was evaluated based on the position of the individualized pieces before transfer.
FIG. 17 is a view illustrating the positional deviation of the individualized pieces before and after transfer. The straight-line distance d from the reference position P0 ($X_0$, $Y_0$) of each individualized piece before transfer to the position P1 ($X_1$, $Y_1$) after transfer was calculated using the following formula (1), and the average value was obtained. The evaluation of transfer position accuracy was determined as A to E shown below according to the average value of the straight-line deviation distance. It is desirable that the evaluation of the transfer position accuracy is C or higher.
[Formula 1]

$$d = \sqrt{(X_0 - X_1)^2 + (Y_0 - Y_1)^2} \quad \cdots \quad (1)$$

A: less than 5μm
B: 5μm or more, less than 10μm
C: 10μm or more, less than 15μm
D: 15μm or more, less than 20μm
E: 20μm or more

EVALUATION OF LIGHTING TEST

For the examples, lighting evaluation was conducted on the mounting body in which the μLED element was mounted using the processed individualized pieces. The mounting body fabrication and lighting evaluation were performed as follows.

FABRICATION OF MOUNTING BODY

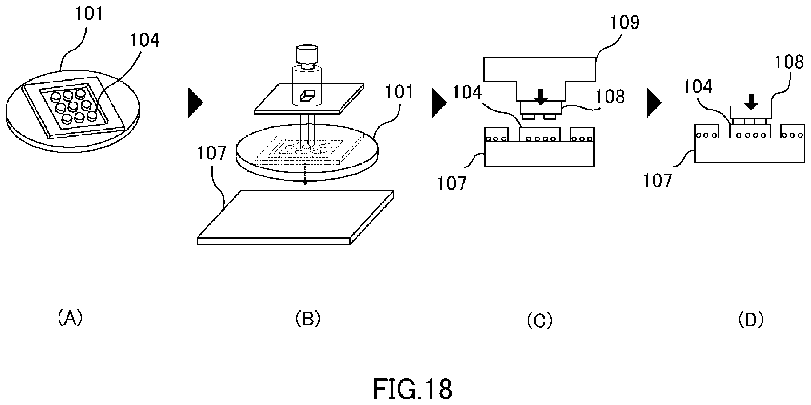

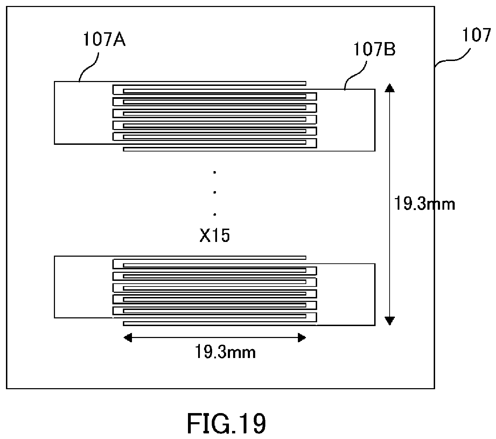

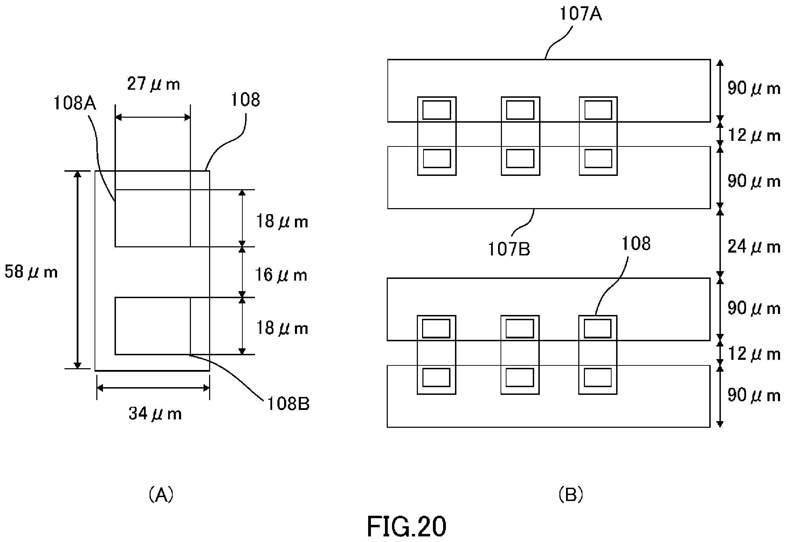

FIG. 18 schematically illustrates a fabrication method of a mounting body, in which FIG. 18 (A) shows the step of preparing individualized pieces, FIG. 18 (B) shows the step of transferring the individualized pieces to a substrate, FIG. 18 (C) shows the step of temporarily fixing a μLED element, and FIG. 18 (D) shows the step of pressure bonding the μLED element. FIG. 19 is a plan view schematically illustrating an evaluation substrate for a lighting test, FIG. 20 (A) is a plan view schematically illustrating an electrode surface of the μLED element, and FIG. 20 (B) is a plan view schematically illustrating a μLED element mounted on an evaluation substrate.
As shown in FIG. 18 (A), first, the individualized pieces 104 of a predetermined shape processed on the aforementioned quartz glass plate 101 was prepared, and as shown in FIG. 18 (B), a laser was irradiated from the rear side (quartz glass plate 101 side) of the individualized piece 104 to transfer the individualized piece 104 to the designated location on the evaluation substrate 107. The transfer of the individualized piece 104 was performed in the same way as the LLO in the aforementioned evaluation of individualized piece transfer.
The evaluation substrate 107 was made by forming a wiring pattern with an undercoat of 20 nm thick Cr and a front surface of 80 nm thick Au on a glass substrate 0.5 mm thick, which has, as shown in FIG. 19, 15 pairs of a first comb-shaped electrode 107A with 6 comb teeth and a second comb-shaped electrode 107B with 6 comb teeth. As shown in FIGS. 19 and 20 (B), the wiring pattern had the comb teeth with a line width of 90 μm and a space width of 12 μm or 24 μm, approximately 1,300 μm per channel x 15 channels ≈ 19.3 mm, and the individualized pieces of the predetermined shape were transferred between the wirings with a space width of 12 μm.

Next, as shown in FIG. 18 (C), a polydimethylsiloxane (PDMS) sheet 109 with μLED elements 108 arranged in the protruding portions was aligned in advance using LLO, and bonded under the conditions of 30°C, 30 MPa, and 10 sec, and as shown in FIG. 20 (B), the μLED elements 108 were temporarily fixed between the wirings with a space width of 12 μm on the evaluation substrate 107 via the individualized pieces 104.

As shown in FIG. 20 (A), the μLED element 108 used had an outer diameter of 34 μm x 58 μm, with the size of the first electrode 108A and the second electrode 108B of 27 μm x 18 μm, and the distance between the first electrode 108A and the second electrode 108B of 16 μm.

Next, as shown in FIG. 18 (D), the μLED elements 108 were all pressed together using a press with the pressing conditions of 150°C, 150N, and 30 sec, thereby fabricating a mounting body with the μLED elements (total 3,600 pcs) mounted thereon.

LIGHTING EVALUATION

A voltage of 3.0V was applied to the first and second comb-shaped electrodes of the mounting body, and the number of lights was counted for all μLED elements (total 3,600 pcs), and the lighting rate was calculated using the following formula. The lighting rate should be 95% or more.

$$\text{lighting rate} = \text{number of lights} / \text{total number} \times 100$$

Example 1

INDIVIDUALIZATION PROCESS OF ANISOTROPIC CONDUCTIVE FILM

Using a laser lift-off device (LUM-XTR manufactured by Shin-Etsu Engineering), laser light was irradiated from the quartz glass plate side of the aforementioned anisotropic conductive film substrate to transfer the unnecessary portions to the plain glass plate, thereby forming individualized pieces of anisotropic conductive film on the quartz glass plate. As shown in the above-mentioned FIG. 1, an example of the laser lift-off device includes: a laser scanner that scans the optical axis of the laser light; a mask having multiple openings of a predetermined shape arranged at a predetermined pitch; a projection lens that reduces and projects the laser light onto the donor substrate; a donor stage that holds the donor substrate; and a receptor stage that holds the receptor substrate, and an anisotropic conductive film substrate, which is the donor substrate, is held on the donor stage, the plain glass plate, which is the receptor substrate, is held on the receptor stage, and the distance between the anisotropic conductive film and the plain glass plate is 100 μm.

An excimer laser with an oscillation wavelength of 248 nm was used for the laser device. The pulse energy of the laser light was 600J, the fluence was 250 J/cm$^2$, the pulse width (irradiation time) was 30,000 picoseconds, the pulse frequency was 0.01 kHz, and the number of irradiation pulses was 1 pulse per individualized piece.

The pulse energy of the laser light irradiated at the interface between the anisotropic conductive film and the quartz glass plate was 0.001 to 2J, the fluence was 0.001 to 2 J/cm$^2$, the pulse width (irradiation time) was 0.01 to 1 x 10$^9$ picoseconds, the pulse frequency was 0.1 to 10,000 Hz, and the number of irradiation pulses was 1 to 30,000,000.

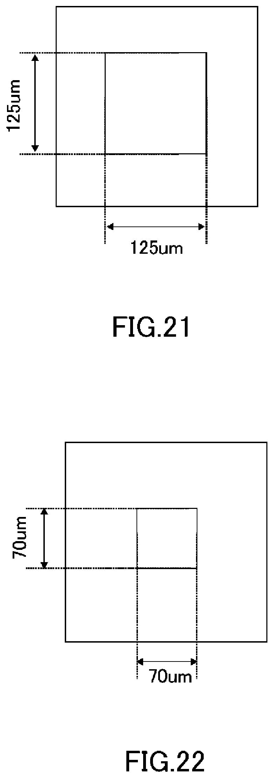

FIG. 21 is a plan view schematically illustrating the mask shape of Example 1. As shown in FIG. 21, in Example 1, a mask having a 125 μm x 125 μm rectangular window was used to make the laser light spot rectangular. After removing the unnecessary portions in the vertical direction of the anisotropic conductive film with the pitch of the rectangle in the vertical direction of the window of the mask, the unnecessary portions in the horizontal direction of the anisotropic conductive film were removed with the pitch of the rectangle in the vertical direction of the window of the mask, thereby forming 100 x 100 pcs (total of 10,000 pcs) of rectangular individualized pieces of 30 μm (horizontal) x 40 μm (vertical) at a pitch of 120 μm in the horizontal direction and 160 μm in the vertical direction.

As shown in Table 1, in Example 1, the non-defective rate of the individualization process was 100%, the burr occurring rate of the individualization process was 2%, and the reaction rate of the individualization process was 20% or less. In addition, in Example 1, the non-defective product rate for the individualized piece transfer was 96%, and the evaluation of the position accuracy was C. In addition, in Example 1, the lighting rate of the lighting test was the same as the non-defective product rate for the individualized piece transfer because the μLED elements of the good product part of the individualized piece transfer lit up.

Example 2

The same method as in Example 1 was used to form 100 x 100 pcs (total of 10,000 pcs) of individualized pieces of

60 μm (horizontal) x 80 μm (vertical) at a pitch of 120 μm in the horizontal direction and 160 μm in the vertical direction.

As shown in Table 1, in Example 2, the non-defective rate of the individualization process was 100%, the burr occurring rate of the individualization process was 0%, and the reaction rate of the individualization process was 20% or less. In addition, in Example 2, the non-defective product rate for the individualized piece transfer was 99% or more, and the evaluation of the position accuracy was C. In addition, the lighting rate for the lighting test in Example 2 was the same as the non-defective product rate for the individualized piece transfer.

Example 3

FIG. 22 is a plan view schematically illustrating the mask shape of Example 3. As shown in FIG. 22, in Example 3, a mask having a 70 μm x 70 μm rectangular window was used to make the laser light spot rectangular. Other than this, the same method as in Example 1 was used to form 100 x 100 pcs (total of 10,000 pcs) of rectangular individualized pieces of 30 μm (horizontal) x 40 μm (vertical) at a pitch of 120 μm in the horizontal direction and 160 μm in the vertical direction.

As shown in Table 1, in Example 3, the non-defective rate of the individualization process was 100%, the burr occurring rate of the individualization process was 5%, and the reaction rate of the individualization process was 20% or less. In addition, in Example 3, the non-defective product rate for the individualized piece transfer was 93%, and the evaluation of the position accuracy was C. In addition, the lighting rate for the lighting test in Example 3 was the same as the non-defective product rate for the individualized piece transfer.

Example 4

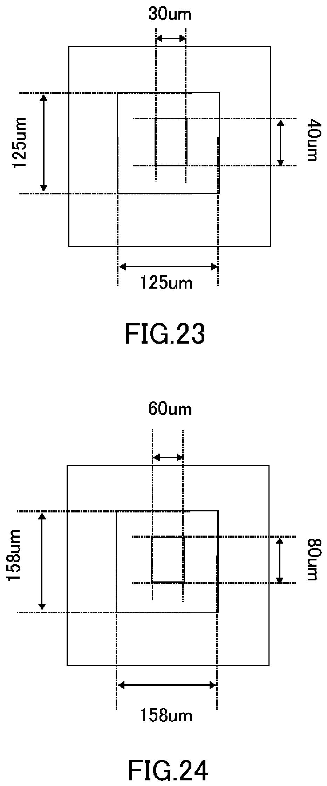

FIG. 23 is a plan view schematically illustrating the mask shape of Example 4. As shown in FIG. 23, in Example 4, a mask having a 30 μm (horizontal) x 40 μm (vertical) rectangular light-shielding portion in the central portion of a 125 μm x 125 μm rectangular window was used so that the shape of the laser light spot was made to have a rectangular shadow in the center of a rectangle. Other than removing the unnecessary portions of the anisotropic conductive film at the pitch of the rectangle in the vertical or horizontal direction of the window of the mask, the same method as in Example 1 was used to form 100 x 100 pcs (total of 10,000 pcs) of rectangular individualized pieces of 30 μm (horizontal) x 40 μm (vertical) at a pitch of 120 μm in the horizontal direction and 160 μm in the vertical direction.

As shown in Table 1, in Example 4, the non-defective rate of the individualization process was 100%, the burr occurring rate of the individualization process was 0%, and the reaction rate of the individualization process was 20% or less. In addition, in Example 4, the non-defective product rate for the individualized piece transfer was 99% or more, and the evaluation of the position accuracy was C. In addition, the lighting rate for the lighting test in Example 4 was the same as the non-defective product rate for the individualized piece transfer.

Example 5

FIG. 24 is a plan view schematically illustrating the mask shape of Example 5. As shown in FIG. 24, in Example 5, a mask having a 60 μm (horizontal) x 80 μm (vertical) rectangular light-shielding portion in the central portion of a 158 μm x 158 μm rectangular window was used so that the shape of the laser light spot was made to have a rectangular shadow in the center of a rectangle. Other than removing the unnecessary portions of the anisotropic conductive film at the pitch of the rectangle in the vertical or horizontal direction of the window of the mask, the same method as in Example 1 was used to form 100 x 100 pcs (total of 10,000 pcs) of rectangular individualized pieces of 60 μm (horizontal) x 80 μm (vertical) at a pitch of 120 μm in the horizontal direction and 160 μm in the vertical direction.

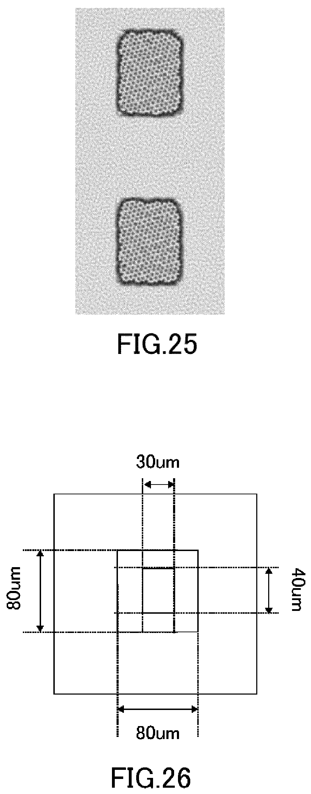

FIG. 25 is a microscope photograph showing the rectangular individualized pieces in Example 5. As shown in FIG. 25, the individualized pieces in Example 5 were almost the same size as the rectangle of the light-shielding portion of the mask shown in FIG. 24. In addition, because the unnecessary portions of the rectangular individualized pieces were torn off using LLO, the outer shape was not a clean straight line, but jagged.

As shown in Table 1, in Example 5, the non-defective rate of the individualization process was 100%, the burr occurring rate of the individualization process was 0%, and the reaction rate of the individualization process was 20% or less. In addition, in Example 5, the non-defective product rate for the individualized piece transfer was 99% or more, and the evaluation of the position accuracy was C. In addition, the lighting rate for the lighting test in Example 5 was the same as the non-defective product rate for the individualized piece transfer.

Example 6

FIG. 26 is a plan view schematically illustrating the mask shape of Example 6. As shown in FIG. 26, in Example 6, a 30 μm (horizontal) x 40 μm (vertical) rectangular light-shielding portion in the central portion of an 80 μm x 80 μm rectangular window was used so that the shape of the laser light spot was made to have a rectangular shadow in the center of a rectangle. Other than the removal of the unnecessary portions of the anisotropic conductive film at the pitch of the rectangle in the vertical or horizontal direction of the window of the mask, the same method as in Example 1 was used to form 100 x 100 pcs (total of 10,000 pcs) of rectangular individualized pieces of 30 μm (horizontal) x 40 μm (vertical) at a pitch of 120 μm in the horizontal direction and 160 μm in the vertical direction.

As shown in Table 1, in Example 6, the non-defective rate of the individualization process was 100%, the burr occurring rate of the individualization process was 1%, and the reaction rate of the individualization process was 20% or less. In addition, in Example 6, the non-defective product rate for the individualized piece transfer was 97%, and the evaluation of the position accuracy was C. In addition, the lighting rate for the lighting test in Example 6 was the same as the non-defective product rate for the individualized piece transfer.

Example 7

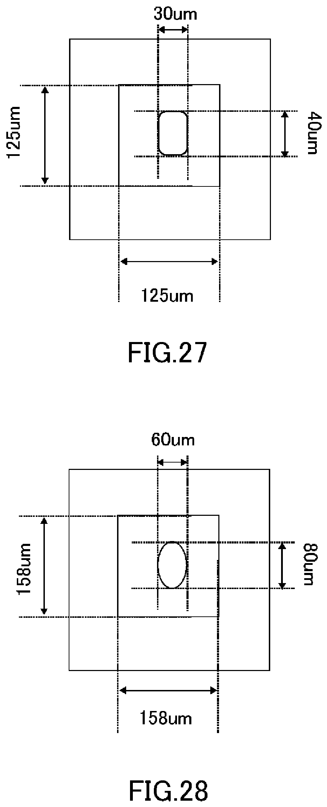

FIG. 27 is a plan view schematically illustrating the mask shape of Example 7. As shown in FIG. 27, in Example 7, a mask having a 30 μm (horizontal) x 40 μm (vertical) rectangular light-shielding portion with rounded corners in the central portion of a 125 μm x 125 μm rectangular window was used so that the shape of the laser light spot was made to have a rectangle with rounded corners in the center of the rectangle. Other than removing the unnecessary portions of the anisotropic conductive film at the pitch of the rectangle in the vertical or horizontal direction of the window of the mask, the same method as Example 1 was used to form 100 x 100 pcs (total of 10,000 pcs) of rounded rectangular individualized pieces of 30 μm (horizontal) x 40 μm (vertical) at a pitch of 120 μm in the horizontal direction and 160 μm in the vertical direction.

As shown in Table 2, in Example 7, the non-defective rate of the individualization process was 100%, the burr occurring rate of the individualization process was 0%, and the reaction rate of the individualization process was 20% or less. In addition, in Example 7, the non-defective product rate for the individualized piece transfer was 99% or more, and the evaluation of the position accuracy was C. In addition, the lighting rate for the lighting test in Example 7 was the same as the non-defective product rate for the individualized piece transfer.

Example 8

FIG. 28 is a plan view schematically illustrating the mask shape of Example 8. As shown in FIG. 28, in Example 8, a mask having a 60 μm (horizontal) x 80 μm (vertical) elliptical light-shielding portion in the central portion of 158 μm x 158 μm rectangular window was used so that the shape of the laser light spot was made to have an elliptical shadow in the center of a rectangle. Other than removing the unnecessary portions of the anisotropic conductive film at the pitch of the rectangle in the vertical or horizontal direction of the window of the mask, the same method as Example 1 was used to form 100 x 100 pcs (total of 10,000 pcs) of elliptical rectangular individualized pieces of 60 μm (horizontal) x 80 μm (vertical) at a pitch of 120 μm in the horizontal direction and 160 μm in the vertical direction.

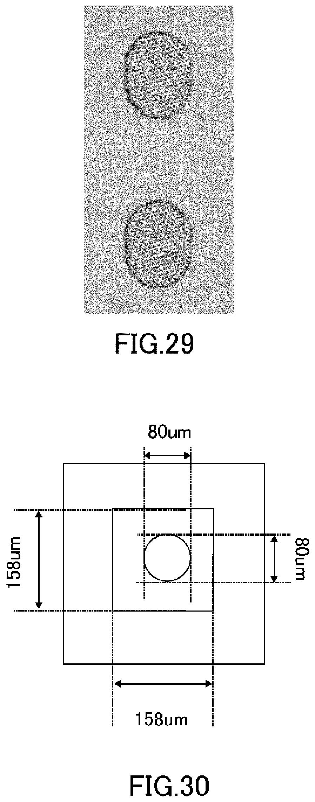

FIG. 29 is a microscope photograph showing the elliptical individualized pieces of Example 8. As shown in FIG. 29, the individualized pieces in Example 8 were almost the same size as the ellipse in the light-shielding portion of the mask shown in FIG. 28. In addition, the elliptical individualized pieces had a clearer outer shape than the rectangular individualized pieces. This is thought to be because there are fewer nearly straight sections than the rectangular individualized pieces.

As shown in Table 2, in Example 8, the non-defective rate of the individualization process was 100%, the burr occurring rate of the individualization process was 0%, and the reaction rate of the individualization process was 20% or less. In addition, in Example 8, the non-defective product rate for the individualized piece transfer was 99% or more, and the evaluation of the position accuracy was B. In addition, the lighting rate for the lighting test in Example 8 was the same as the non-defective product rate for the individualized piece transfer.

Example 9

FIG. 30 is a plan view schematically illustrating the mask shape of Example 9. As shown in FIG. 30, in Example 9, a mask having an 80 μm (horizontal) x 80 μm (vertical) circular light-shielding portion in the central portion of 158 μm x 158 μm rectangular window was used so that the shape of the laser light spot was made to have a circular shadow in the center of a rectangle. Other than removing the unnecessary portions of the anisotropic conductive film at the pitch of the rectangle in the vertical or horizontal direction of the window of the mask, the same method as Example 1 was used 100 x 100 pcs (total of 10,000 pcs) of circular individualized pieces of 80 μm (horizontal) x 80 μm (vertical) at a pitch of 120 μm in the horizontal direction and 160 μm in the vertical direction.

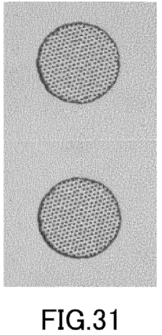

FIG. 31 is a microscope photograph showing the circular individualized pieces of Example 9. As shown in FIG. 31, the individualized pieces in Example 9 were approximately the same size as the circle in the light-shielding portions of the mask shown in FIG. 30. In addition, the circular individualized pieces had a clearer outer shape than the rectangular individualized pieces. This is thought to be because there are fewer nearly straight sections than the rectangular individualized pieces.

As shown in Table 2, in Example 9, the non-defective rate of the individualization process was 100%, the burr occurring rate of the individualization process was 0%, and the reaction rate of the individualization process was 20% or less. In addition, in Example 9, the non-defective product rate for the individualized piece transfer was 99% or more, and the evaluation of the position accuracy was A. In addition, the lighting rate for the lighting test in Example 9 was the same as the non-defective product rate for the individualized piece transfer.

Comparative Example 1

Using a laser lift-off device (LUM-XTR manufactured by Shin-Etsu Engineering), laser light was irradiated from the side of the anisotropic conductive film attached to a 4-inch quartz glass plate, and the unnecessary portions were sublimated by laser ablation to form an individualized piece of the anisotropic conductive film on the quartz glass plate.

An excimer laser with an oscillation wavelength of 248 nm was used for the laser device. The pulse energy of the laser light was 600J, the fluence was 500 J/cm$^2$, the pulse width (irradiation time) was 30,000 picoseconds, the pulse frequency was 0.01 kHz, and the number of irradiation pulses was 10 pulses per individualized piece.

A mask having a 125 $\mu$m x 125 $\mu$m rectangular window was used to make the laser light spot rectangular. After removing the unnecessary portions in the vertical direction of the anisotropic conductive film with the pitch of the rectangle in the vertical direction of the window of the mask, the unnecessary portions in the horizontal direction of the anisotropic conductive film were removed with the pitch of the rectangle in the vertical direction of the window of the mask, thereby forming 100 x 100 pcs (total of 10,000 pcs) of rectangular individualized pieces of 30 $\mu$m (horizontal) x 40 $\mu$m (vertical) at a pitch of 120 $\mu$m in the horizontal direction and 160 $\mu$m in the vertical direction.

As shown in Table 2, in Comparative Example 1, the non-defective rate of the individualization process was 100%, the burr occurring rate of the individualization process was 2%, and the reaction rate of the individualization process was 70% or more. In addition, in Comparative Example 1, the non-defective product rate for the individualized piece transfer was 0%, and the evaluation of the position accuracy was E.

Comparative Example 2

Using a blade dicing machine with a 20$\mu$m blade, anisotropic conductive film attached to a 4-inch quartz glass plate was attempted to processed to form 100 x 100 pcs (total of 10,000 pcs) of individualized pieces of 60 $\mu$m (horizontal) x 80 $\mu$m (vertical) at a pitch of 120 $\mu$m (horizontal) and 160 $\mu$m (vertical), but this individualization process was failed. As shown in Table 2, in Comparative Example 2, the non-defective rate of the individualization process was 0%.

Table 1 shows the evaluation results for the individualization process and the individualized piece transfer in Examples 1 to 6, and Table 2 shows the evaluation results for the individualization process and the individualized piece transfer in Examples 7 to 9 and Comparative Examples 1 and 2.

Table 1

| | | | Ex. 1 | Ex. 2 | Ex. 3 | Ex. 4 | Ex. 5 | Ex. 6 |
|---|---|---|---|---|---|---|---|---|
| manufacturing method | | | LLO method | LLO method | LLO method | LLO method | LLO method | LLO method |
| mask shape | | | rectangular window | rectangular window | rectangular window | rectangular light-shielding portion in rectangular window | rectangular light-shielding portion in rectangular window | rectangular light-shielding portion in rectangular window |
| piece size(horizontal × virtical um) | | | 30 × 40 | 60 × 80 | 30 × 40 | 30 × 40 | 60 × 80 | 30 × 40 |
| individualization | | non-defective rate(%) | 100 | 100 | 100 | 100 | 100 | 100 |
| | | burr occurring rate(%) | 2 | 0 | 5 | 0 | 0 | 1 |
| | | reaction rate(%) | ≦ 20 | ≦ 20 | ≦ 20 | ≦ 20 | ≦ 20 | ≦ 20 |

(continued)

|  |  | Ex. 1 | Ex. 2 | Ex. 3 | Ex. 4 | Ex. 5 | Ex. 6 |
|---|---|---|---|---|---|---|---|
| piece transfer | non-de-fective product rate(%) | 96 | 99 ≦ | 93 | 99 ≦ | 99 ≦ | 97 |
|  | position accuracy | C | C | C | C | C | C |
| lighting test | lighting rate(%) | 96 | 99 ≦ | 93 | 99 ≦ | 99 ≦ | 97 |

Table 2

|  |  | Ex. 7 | Ex. 8 | Ex. 9 | Comp. 1 | Comp. 2 |
|---|---|---|---|---|---|---|
| manufacturing method | | LLO method | LLO method | LLO method | laser di-cing | blade di-cing |
| mask shape | | rounded rectangu-lar light-shielding portion in rectangular window | elliptical light-shielding por-tion in rectan-gular window | circular light-shielding por-tion in rectan-gular window | - | - |
| piece size(horizontal × virtical um) | | 30 × 40 | 60 × 80 | 80 × 80 | 30 × 40 | 60 × 80 |
| individualization | non-defective rate(%) | 100 | 100 | 100 | 100 | 0 |
|  | burr occurring rate(%) | 0 | 0 | 0 | - | - |
|  | reaction rate(%) | ≦ 20 | ≦ 20 | ≦ 20 | 70 ≦ | - |
| piece transfer | non-defective product rate(%) | 99 ≦ | 99 ≦ | 99 ≦ | 0 | - |
|  | position accuracy | C | B | A | E | - |
| lighting test | lighting rate(%) | 99 ≦ | 99 ≦ | 99 ≦ | - | - |

Comparative Example 1 had a high individualized piece reaction rate of over 70%. This is thought to be because the irradiation of the laser light from the anisotropic conductive film side, and the large fluence and the large number of irradiation pulses used to sublimate the unnecessary portions caused the surrounding individualized pieces to be affected by radiant heat. In addition, because the reaction rate of the individualized pieces was high in Comparative Example 1, it was difficult to transfer the individualized pieces. In Comparative Example 2, because a blade dicing device was used, it was not possible to create small individualized pieces of 60 μm (horizontal) x 80 μm (vertical).

In Examples 1 to 9, the laser lift-off device was used to irradiate laser light from the base material side to remove the anisotropic conductive film in the irradiated area, so the reaction rate of the individualized pieces was kept below 25%. As a result, it was able to obtain excellent evaluation results for the individualization process and the individualized piece transfer. In addition, in Examples 4 to 9, the use of a mask having a light-shielding portion in the shape of the individualized pieces within the window of the opening helped to suppress the burr occurring rate. This is thought to be because the mask with the light-shielding portion in the shape of the individualized pieces was able to reliably remove the anisotropic conductive film on the peripheral edge portion of the individualized pieces. In addition, Examples 7 to 9 had particularly excellent evaluation results for the individualized piece transfer. This is thought to be because there are no sharp corners in the shape of the individualized pieces, and this was able to suppress the occurrence of curling and chipping in the individualized piece transfer. In addition, the lighting rate in the lighting tests for Examples 1 to 9 was the same as the non-defective product rate for the individualized piece transfer.

REFERENCE SIGNS LIST

10 laser lift-off device, 11 laser scanner, 12 mask, 13 projection lens, 20 curable resin film substrate, 21 base material, 22 curable resin film, 23 removal portion, 30 curable resin film substrate, 31 base material, 32 curable resin film, 33 removal portion, 34 individualized piece, 41 individualized piece with burrs, 42 individualized piece with curling, 43 individualized piece with chips, 51 light-shielding portion, 52 individualized piece, 53 light-shielding portion, 54A to 54D light-shielding portions, 60 individualized-piece-film, 61 base material, 62 anisotropic conductive film, 63 conductive particles, 64 individualized piece, 64A individualized piece, 64B individualized piece, 70 wiring substrate, 71 base material, 72 first electrode, 73 second electrode, 80 light-emitting element, 81 main body, 82 first conductivity-type electrode, 83 second conductivity-type electrode, 90 transfer substrate, 91 base material, 101 quartz glass plate, 104 individualized piece, 107 evaluation substrate, 107A first comb-shaped electrode, 107B second comb-shaped electrode, 108 μLED element, 108A first electrode, 108B second electrode, 109 PDMS sheet

## Claims

1. A mask comprising a light-shielding portion of a predetermined shape that blocks laser light within an opening that allows laser light to pass through, wherein
the laser light is allowed to pass around the periphery of the light-shielding portion.

2. The mask according to claim 1, wherein the predetermined shape is at least one selected from a polygon with obtuse angles, a polygon with rounded corners, an ellipse, an oval, and a circle.

3. A method for manufacturing a mask, wherein with respect to a transparent substrate on which a light-shielding film is formed, the light-shielding film is removed so that the mask includes a light-shielding portion of a predetermined shape that blocks laser light within an opening that allows laser light to pass through.

4. A method for manufacturing a display device, comprising:

   a formation step of irradiating a curable resin film formed on a base material with laser light from the base material side to remove the curable resin film in the irradiated area, thereby forming individualized pieces of a predetermined shape composed of the curable resin film with a reaction rate of 25% or less on the base material;
   a transfer step of transferring the individualized pieces of the predetermined shape to a predetermined position on a wiring substrate or to an electrode surface of a light-emitting element; and
   a mounting step of mounting the light-emitting element to the wiring substrate via the transferred individualized pieces.

5. The method for manufacturing a display device according to claim 4, wherein in the formation step, the laser light is irradiated via the mask having a light-shielding portion of the predetermined shape.

6. The method for manufacturing a display device according to claim 4, wherein in the transfer step, the individualized pieces of the predetermined shape are transferred to a predetermined position of the wiring substrate or to an electrode surface of the light-emitting element by irradiating laser light from the base material side.

7. The method for manufacturing a display device according to claim 4, wherein the predetermined shape is at least one selected from a polygon with obtuse angles, a polygon with rounded corners, an ellipse, an oval, and a circle.

8. The method for manufacturing a display device according to claim 4, wherein the individualized pieces are arranged on the base material.

9. The method for manufacturing a display device according to claim 8, wherein the distance between the individualized pieces is 10 μm or more.

10. A display device, comprising:

a plurality of light-emitting elements;
a wiring substrate on which the light-emitting elements are arranged; and
a cured film that connects the plurality of light-emitting elements to the wiring substrate, wherein
the cured film is made by curing individualized pieces of a predetermined shape composed of a curable resin film, and
the predetermined shape is at least one selected from a polygon with obtuse angles, a polygon with rounded corners, an ellipse, an oval, and a circle.

11. The display device according to claim 10, wherein the distance between the individualized pieces is 10 $\mu$m or more.

12. The display device according to claim 10, wherein the light-emitting elements are arranged in units of subpixels that constitute a pixel.

13. The display device according to claim 10, wherein the individualized pieces are arranged on the wiring substrate in units of subpixels or pixels.

FIG.1

(A)                  (B)                  (C)                  (D)

FIG.2

(A)

(B)

FIG.3

(A)

— 41

— 42

— 43

(B)

FIG.4

51

52

(A)                    (B)

## FIG.5

53

W2

W1

## FIG.6

54A     54B     54C     54D

(A)     (B)     (C)     (D)

FIG.7

61

t

X

62

63

FIG.8

60

61

64
63

73
72
71

70

FIG.9

60

61

64

73
72
71

FIG.10
70

FIG.11

FIG.12

FIG.13

FIG.14

FIG.15

FIG.16

FIG.17

(A)  (B)  (C)  (D)

FIG.18

EP 4 588 605 A1

FIG.19

(A)

(B)

FIG.20

EP 4 588 605 A1

FIG.21

FIG.22

FIG.23

FIG.24

FIG.25

30um

80um

40um

80um

FIG.26

FIG.27

FIG.28

FIG.29

FIG.30

FIG.31

## INTERNATIONAL SEARCH REPORT

| | International application No. |
| --- | --- |
| | **PCT/JP2023/028273** |

| | |
| --- | --- |
| **A.** | **CLASSIFICATION OF SUBJECT MATTER** |

***B23K 26/066***(2014.01)i; ***B23K 26/361***(2014.01)i; ***G09F 9/00***(2006.01)i; ***G09F 9/33***(2006.01)i; ***H01L 33/00***(2010.01)i; ***H01L 33/62***(2010.01)i

FI: B23K26/066; H01L33/00 L; H01L33/62; B23K26/361; G09F9/33; G09F9/00 338

According to International Patent Classification (IPC) or to both national classification and IPC

| | |
| --- | --- |
| **B.** | **FIELDS SEARCHED** |

Minimum documentation searched (classification system followed by classification symbols)

B23K26/066; B23K26/361; G09F9/00; G09F9/33; H01L33/00; H01L33/62

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| X | JP 2004-233251 A (MATSUSHITA ELECTRIC IND. CO., LTD.) 19 August 2004 (2004-08-19) paragraphs [0039]-[0042], fig. 3 | 1-2 |
| Y | | 3 |
| Y | JP 53-71398 A (HITACHI, LTD.) 24 June 1978 (1978-06-24) page 2, upper left column, line 4 to upper right column, line 20, fig. 4-7 | 3 |
| A | WO 2017/150257 A1 (DEXERIALS CORP.) 08 September 2017 (2017-09-08) entire text, all drawings | 4-13 |
| A | JP 2010-20925 A (HITACHI DISPLAYS, LTD.) 28 January 2010 (2010-01-28) entire text, all drawings | 4-13 |

☐ Further documents are listed in the continuation of Box C. ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **05 September 2023** | **19 September 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/028273**

| Patent document cited in search report | | | Publication date (day/month/year) | Patent family member(s) | Publication date (day/month/year) |
|---|---|---|---|---|---|
| JP | 2004-233251 | A | 19 August 2004 | (Family: none) | |
| JP | 53-71398 | A | 24 June 1978 | (Family: none) | |
| WO | 2017/150257 | A1 | 08 September 2017 | JP 2017-157724 A<br>US 2019/0244937 A1<br>entire text, all drawings<br>KR 10-2018-0104071 A<br>CN 108701743 A | |
| JP | 2010-20925 | A | 28 January 2010 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022145312 A
- US 20150255505
- JP 6187665 B